# EUROPÄISCHE PATENTSCHRIFT

(11) **EP 3 695 213 B1**
(45) Veröffentlichungstag und Bekanntmachung des Hinweises auf die Patenterteilung: **12.02.2025**
(21) Anmeldenummer: 18779355.9
(22) Anmeldetag: 26.09.2018
(51) Int. Cl.: G01N 24/08, G01R 33/30, G01R 33/341, G01R 33/38, G01R 33/383, G01R 33/565, G01R 33/34, G01R 33/422

(54) **SENSOR FÜR EINE KERNSPINRESONANZVORRICHTUNG**
SENSOR FOR A NUCLEAR MAGNETIC RESONANCE DEVICE
CAPTEUR POUR UN DISPOSITIF DE RÉSONANCE DE SPIN NUCLÉAIRE

(30) Priorität: 09.10.2017 DE 102017217875
(43) Veröffentlichungstag der Anmeldung: 19.08.2020
(73) Patentinhaber: Robert Bosch GmbH, 70442 Stuttgart (DE)
(72) Erfinder: KRAPF, Reiner, 70794 Filderstadt (DE); HOFFMANN, Ulli, 75223 Niefern-Oeschelbronn (DE); LEDWIG, Michael, 97070 Würzburg (DE); WINTZHEIMER, Stefan, 97282 Retzstadt (DE); DRIESLE, Toni, 87600 Kaufbeuren (DE)
(86) Internationale Anmeldenummer: PCT/EP2018/076125
(87) Internationale Veröffentlichungsnummer: WO 2019/072567

(56) Entgegenhaltungen:
- WO-A1-2006/061618
- DE-A1- 102014 218 375
- DE-U1- 202006 002 074
- US-A1- 2010 244 828
- ASHVIN BASHYAM ET AL: "Unilateral Linear Halbach magnets for single sided magnetic resonance: generalized design framework and experimental validation", PROCEEDINGS OF THE INTERNATIONAL SOCIETY FOR MAGNETIC RESONANCE IN MEDICINE, ISMRM, 25TH ANNUAL MEETING AND EXHIBITION, HONOLULU, HAWAII, USA, 22-27 APRIL 2017, no. 2676, 7 April 2017 (2017-04-07), XP040690244

## Beschreibung

Die Erfindung betrifft einen Sensor für eine Kernspinresonanzvorrichtung mit einer Magnetfelderzeugungseinrichtung umfassend eine planare Magnetanordnung und eine Messeinrichtung. Die Erfindung umfasst ferner eine Kernspinresonanzvorrichtung mit wenigstens einem solchen Sensor.

Es sind bereits Magnetfelderzeugungseinrichtungen mit einer planaren Magnetanordnung bekannt, beispielsweise aus WO 2006/061618 A1, US 2010/244828 A1, DE 10 2014 218375 A1 und DE 20 2006 002074 U1.

Ashvin Bashyam et al, Proc. ISMRM, 2676, 2017, XP40690244, offenbart eine einseitige NMR Vorrichtung zur portablen Diagnose von Unordnungen in Flüssigkeiten.

Kernspinresonanz bzw. magnetische Kernresonanz (NMR, engl. nuclear magnetic resonance) wird in verschiedenen technischen Anwendungen zum Messen von Materialeigenschaften verwendet. Das Messprinzip basiert dabei auf einem physikalischen Effekt, bei dem die zu untersuchende Materialprobe externen Magnetfeldern ausgesetzt und die Änderung der Magnetisierung der Atomkerne innerhalb der Materialprobe als Reaktion auf die externen Magnetfelder gemessen wird. Insbesondere werden die Atomkerne in der Materialprobe zunächst mittels eines ersten Magnetfeldes (B0-Feld) ausgerichtet. In dieser Anordnung befinden sich die Kernspins der Atomkerne in Resonanz mit dem ersten Magnetfeld, wobei die Spins der Atomkerne mit der sogenannten Larmorfrequenz um die Magnetfeldlinien (Larmorpräzession) präzidieren. Wird die Materialprobe anschließend einem zweiten Magnetfeld (B1-Feld) ausgesetzt, welches orthogonal zum ersten Magnetfeld ausgerichtet ist, so können die sich im ersten Kernspinzustand befindliche Atomkerne die Orientierung ihres Spins durch Absorption von Energie des zweiten Magnetfelds ändern. Wird das zweite Magnetfeld wieder abgeschaltet, wobei die Materialprobe weiterhin dem ersten Magnetfeld ausgesetzt bleibt, ergibt sich für die Atomkerne mit den zuvor ausgelenkten Kernspins ein angeregter Kernspinzustand, aus dem sie in einem Relaxationsprozess wieder in den energetisch niedrigeren ersten Kernspinzustand zurückkehren, in welchem ihre Kernspins an den

Magnetfeldlinien des ersten Magnetfelds ausgerichtet sind. Der Relaxationsprozess erfolgt dabei unter Emission elektromagnetischer Strahlung, welche sich in einer Magnetfeldänderung bemerkbar macht. Diese Magnetfeldänderung lässt sich als Antwortsignal mithilfe einer geeigneten Detektions- bzw. Messeinrichtung in Form einer Antenne bzw. Spule erfassen. Bei geeigneter Wahl der Betriebsparameter der Kernspinresonanzvorrichtung kann durch Auswertung der Amplitude und des zeitlichen Verlaufs des Antwortsignals auf die Relaxationszeiten der Kernspins und damit auf die Menge bzw. Konzentration bestimmter Atome in der Materialprobe geschlossen werden. Da mittels Kernspinresonanz insbesondere Wasserstoffatome detektiert werden können, eignet sich diese Messmethode optimal zur Bestimmung der Menge bzw. Verteilung von Wasser in der Materialprobe.

Dabei wird als erstes Magnetfeld insbesondere ein statisches Magnetfeld mit definierten Eigenschaften und als zweites Magnetfeld ein elektromagnetisches Wechselfeld, wie zum Beispiel ein gepulstes Magnetfeld, verwendet.

Um eine optimale Kernresonanz-Messung zu erzielen, sind besonders präzise und homogene Magnetfelder in dem zu messenden Volumen bzw. in der zu messenden Schicht notwendig. Insbesondere muss auch die Orthogonalität der Magnetfelder in dem Nutzvolumen sichergestellt werden. Aus diesem Grund werden Kernspinresonanzvorrichtungen typischerweise in Form eines geschlossenen Zylinders ausgebildet. Diese Bauweise schränkt die Verwendung der Kernspinresonanzvorrichtung ein, da nur solche Materialproben gemessen werden können, welche in das Innere des Zylinders hineinpassen.

Es ist daher Aufgabe der Erfindung, eine Möglichkeit zum Messen größerer beziehungsweise flächiger Materialproben mithilfe der Kernspinresonanz bereitzustellen. Diese Aufgabe wird durch einen Sensor gemäß Anspruch 1 sowie durch eine Kernspinresonanzvorrichtung gemäß Anspruch 18 gelöst.

Weitere vorteilhafte Ausführungsformen sind in den abhängigen Ansprüchen angegeben.

Gemäß der Erfindung ist ein Sensor für eine Kernspinresonanzvorrichtung zum Bestimmen wenigstens einer Materialeigenschaft einer in einem Nutzvolumen angeordneten Materialprobe nach Anspruch 1 vorgesehen. Die Kernspinresonanzvorrichtung umfasst dabei eine Magnetfelderzeugungseinrichtung umfassend eine planare Magnetanordnung zum Erzeugen eines statischen Magnetfelds in dem Nutzvolumen, wobei die planare Magnetanordnung auf einer den Nutzvolumen zugewandten Vorderseite mehrere magnetische Pole aufweist, welche entlang einer ersten Erstreckungsrichtung der planaren Magnetanordnung mit jeweils alternierender Ausrichtung nebeneinander angeordnet sind. Die Kernspinresonanzvorrichtung umfasst ferner eine Messeinrichtung zum Messen eines auf Kernspinresonanz der im Nutzvolumen angeordneten Materialprobe basierenden Antwortsignals umfassend eine elektrische Spule mit wenigstens einer Wicklung zum Erzeugen eines magnetischen Wechselfelds in dem Nutzvolumen. Dabei ist die Wicklung zwischen zwei unmittelbar benachbarten magnetischen Polen der planaren Magnetanordnung angeordnet, so dass sich das magnetische Wechselfeld der elektrischen Spule im Nutzvolumen im Wesentlichen orthogonal mit dem statischen Magnetfeld der planaren Magnetanordnung überlagert. Aufgrund der speziellen Anordnung der Magnetpole der beiden Magnetfelder, wobei die Magnetpole des magnetischen Wechselfelds jeweils versetzt zu den Magnetpolen des statischen Magnetfelds angeordnet sind, stellt sich im Nutzvolumen bei geeigneter Wahl der Betriebsparameter automatisch eine Orthogonalität zwischen den Feldlinien des statischen Magnetfelds und den Feldlinien des magnetischen Wechselfelds ein. Hierdurch wird ein sich parallel zum Kernspinresonanzsensor erstreckendes Nutzvolumen definiert, In welchem ausreichend gute Bedingungen für eine NMR-Messung vorliegen. Das Nutzvolumen ist dabei außerhalb der Kernspinresonanzvorrichtung angeordnet. Ferner weist der Sensor aufgrund der planaren Magnetanordnung einen flachen Aufbau auf. Da ein solcher Sensor die Materialprobe nicht umschließt, ist die Größe der zu vermessenden Materialprobe nicht eingeschränkt. Insbesondere können mithilfe eines solchen Sensors auch flächige Objekte vermessen werden, wie zum Beispiel eine Hauswand. Dabei kann der Sensor aufgrund der flachen Bauweise unter anderem auch als ein tragbares Gerät ausgebildet werden, z.B. in Form eines Handgeräts.

Ferner ist der Sensor aufgrund der flachen Bauweise besonders kompakt.

Hierdurch ergibt sich ein äußerst günstiges Verhältnis von Sensorgröße und nutzbaren NMR-sensitiven Volumen. Durch die Kompaktheit ergibt sich auch eine gute Transportierbarkeit des Sensors bzw. einer mit einem solchen Sensor ausgestatteten Kernspinresonanzvorrichtung.

Erfindungsgemäß ist vorgesehen, dass die planare Magnetanordnung entlang der ersten Erstreckungsrichtung und entlang einer zweiten Erstreckungsrichtung, die senkrecht zur ersten Erstreckungsrichtung verläuft, jeweils mehrere nebeneinander angeordnete Magnetsegmente mit jeweils orthogonal zur zweiten Erstreckungsrichtung der planaren Magnetanordnung ausgerichteten Magnetisierungsrichtungen umfasst. Dabei weisen die Magnetsegmente, welche entlang der ersten Erstreckungsrichtung der planaren Magnetanordnung unmittelbar nebeneinander angeordnet sind, jeweils relativ zueinander verdrehte Magnetisierungsrichtungen auf, wodurch auf der Vorderseite der planaren Magnetanordnung ein wesentlich stärkeres statisches Magnetfeld erzeugt wird als auf der Rückseite der planaren Magnetanordnung. Durch die unterschiedliche Orientierung der Magnetisierungsrichtungen unmittelbar benachbarter Magnetsegmente kann der magnetische Fluss des statischen Magnetfelds im Wesentlichen auf der Vorderseite der planaren Magnetanordnung konzentriert werden. Diese Anordnung, welche beispielsweise in Form eines planaren bzw. aufgerollten Halbach-Arrays ausgebildet sein kann, ermöglicht eine deutliche Erhöhung der Feldstärke des statischen Magnetfelds im Nutzvolumen. Dabei kann eine die notwendig hohe Feldstärke mit relativ einfachen Magneten erreicht werden, beispielsweise mit Standardmagneten.

Diese Anordnung erlaubt ferner eine besonders flexible Bauweise des Sensors, wobei sich die Anzahl der magnetischen Pole und ihre Position entlang der ersten Erstreckungsrichtung der planaren Magnetanordnung den jeweiligen Anforderungen anpassen lässt.

In einer weiteren Ausführungsform ist vorgesehen, dass entlang der ersten Erstreckungsrichtung der planaren Magnetanordnung unmittelbar nebeneinander angeordnete Magnetsegmente jeweils um 45° zueinander verdrehte Magnetisierungsrichtungen aufweisen. Hierdurch ergibt sich ein relativ einfacher Aufbau, mithilfe dessen eine ausreichend hohe Konzentration des statischen Magnetfelds auf der Vorderseite der Magnetanordnung möglich ist. Gleichzeitig kann damit im Vergleich zu einer Magnetanordnung mit um 90° gegeneinander verdrehten Magnetsegmenten eine deutlich feinere Abstufung des Magnetfelds und damit verbunden eine homogenere Feldverteilung im Nutzvolumen erzielt werden.

In einer weiteren Ausführungsform ist vorgesehen, dass auf der Vorderseite der planaren Magnetanordnung vier magnetische Pole mit jeweils alternierenden Ausrichtungen ausgebildet sind. Dabei umfasst die elektrische Spule der Messeinrichtung drei nebeneinander angeordnete Wicklungen, deren magnetische Pole jeweils zwischen zwei unmittelbar benachbarten magnetischen Polen der planaren Magnetanordnung angeordnet sind. Diese Bauweise stellt eine optimierte Anordnung der, mit deren Hilfe ein hinreichend homogenes magnetisches Feld im Nutzvolumen erzeugt werden kann. Darüber hinaus lässt sich damit ein relativ kompaktes Sensormodul realisieren.

In einer weiteren Ausführungsform ist vorgesehen, dass die elektrische Spule ferner zum Messen eines auf Kernspinresonanz der im Nutzvolumen angeordneten Materialprobe basierenden Signals ausgebildet ist. Hierdurch lässt sich der Aufbau vereinfachen, da keine gesonderten Spulen für die Anregung und für die Detektion notwendig sind. Allerdings lassen sich für die Anregung und die Detektion auch separate Spulen verwenden.

In einer weiteren Ausführungsform ist vorgesehen, dass die elektrische Spule auf der Vorderseite der planaren Magnetanordnung angeordnet ist. Hierdurch wird die Empfindlichkeit der elektrischen Spule insbesondere bei der Detektion des Antwortsignals erhöht.

In einer weiteren Ausführungsform ist vorgesehen, dass die elektrische Spule in Form einer strukturierten elektrisch leitfähigen Schicht ausgebildet ist. Hierdurch wird eine besonders flache Bauweise der elektrischen Spule und damit des gesamten Sensors ermöglicht. Dabei kann die elektrische Spule beispielsweise mittels eines fotolithografischen Prozesses erzeugt werden, was eine besonders hohe Präzision ermöglicht.

In einer weiteren Ausführungsform ist vorgesehen, dass in der elektrisch leitfähigen Schicht ferner wenigstens eine Shim-Spule zur Homogenisierung des von der planaren Magnetanordnung in Nutzvolumen erzeugten statischen Magnetfelds ausgebildet ist. Mithilfe solcher Shim-Spulen sind besonders präzise Magnetfelder möglich. Die Integration der Shim-Spule in die elektrisch leitfähige Schicht ermöglicht hingegen eine besonders flache Bauweise.

Erfindungsgemäß ist vorgesehen, dass die elektrische Spule in Form einer multiresonanten Spule ausgebildet ist. Mithilfe der multiresonanten Spule lassen sich Wechselfelder mit unterschiedlicher Frequenz erzeugen bzw. detektieren. Mithilfe der multiresonanten Spule ist es ferner auch möglich, verschiedene Schichten gleichzeitig zu vermessen, wobei die Unterscheidung zwischen den einzelnen Schichten über einen feldabhängigen Kontrast erfolgen kann.

In einer weiteren Ausführungsform ist vorgesehen, dass zwischen der elektrischen Spule und der planaren Magnetanordnung eine innere Abschirmstruktur aus einem elektrisch leitfähigem Material mit einer hohen magnetischen Permeabilität angeordnet ist, welche den Magnetsegmenten als Abschirmung vor dem magnetischen Wechselfeld der elektrischen Spule dient. Mithilfe der inneren Abschirmstruktur kann das von der elektrischen Spule erzeugte magnetische Wechselfeld im Bereich der Permanentmagnete abgeschirmt werden. Hierdurch werden mechanische Kräfte verhindert, welche auf die Permanentmagnete aufgrund des magnetischen bzw. elektromagnetischen Wechselfelds einwirken. Da solche mechanischen Kräfte das Messsignal verfälschen können, kann mithilfe dieser Maßnahme die Messgenauigkeit des Sensors erhöht werden.

In einer weiteren Ausführungsform ist vorgesehen, dass zwischen der elektrischen Spule und dem Nutzvolumen eine äußere Abschirmstruktur aus einem elektrisch leitfähigem Material mit einer hohen magnetischen Permeabilität angeordnet ist, welche der elektrischen Spule als Abschirmung gegen elektromagnetische Störfelder dient. Mithilfe der äußeren Abschirmstruktur lassen sich unerwünschte elektromagnetische Einflüsse auf die magnetische Spule verhindern. Hierdurch lässt sich die Messgenauigkeit erhöhen. Durch die Verwendung eines Materials mit einer hohen magnetischen Permeabilität kann eine unerwünschte Dämpfung des statischen Magnetfelds im Nutzvolumen verhindert werden.

In einer weiteren Ausführungsform ist vorgesehen, dass die äußere Abschirmstruktur Resonanzstrukturen aufweist, welche zur gezielten Abschirmung elektromagnetischer Störfelder mit Frequenzen im Bereich der Netzfrequenz dienen. Mithilfe solcher Resonanzstrukturen lässt sich eine Abschirmstruktur erzeugen, welche nur Störsignale bestimmter Frequenzen abschirmt. Dies ist insbesondere für Frequenzen im Bereich der Netzfrequenz notwendig, da solche Störfelder häufig in technischen Anwendungen vorkommen. Somit kann durch die gezielte Abschirmung von Netzfrequenzen die Messgenauigkeit deutlich erhöht werden.

In einer weiteren Ausführungsform ist vorgesehen, dass die Magnetfelderzeugungseinrichtung eine Trägerplatte aus einem nichtmagnetischen Material umfasst, wobei die Magnetsegmente in wenigstens einer Öffnung der Trägerplatte eingebracht sind. Diese Anordnung ermöglicht eine besonders einfache und kostengünstige Bauweise. Die einzelnen Magnetsegmente können dabei relativ einfach ein- und ausgebaut werden. Hierdurch ist es möglich, die Magnetsegmente beispielsweise für den Transport aus der Trägerplatte zu entfernen. Ferner kann das statische Magnetfeld durch Verdrehen oder Vertauschen der Magnetsegmente innerhalb der Trägerplatte für den Transport oder Lagerung des Sensors gedämpft werden. Darüber hinaus können die Magnetsegmente auch einzeln ausgetauscht werden, wodurch eine Anpassung des statischen Magnetfelds an die jeweilige Anwendung möglich ist.

In einer weiteren Ausführungsform ist vorgesehen, dass wenigstens ein Teil der Magnetsegmente der Magnetanordnung drehbar innerhalb der Trägerplatte ausgebildet ist. Hierdurch ist es möglich, dass statische Magnetfeld durch Drehen der einzelnen Magnetsegmenten den jeweiligen Vorgaben anzupassen. Insbesondere kann durch ein geeignetes Drehen bestimmter Magnetsegmente das statische Magnetfeld im Nutzvolumen reduziert werden, was insbesondere für die Lagerung und den Transport der Kernspinresonanzvorrichtung vorteilhaft ist.

In einer weiteren Ausführungsform ist vorgesehen, dass die Magnetfelderzeugungseinrichtung durch Nebeneinanderanordnung mehrerer Trägerplatten in wenigstens einer der beiden Erstreckungsrichtungen der planaren Magnetanordnung modular erweiterbar ist. Diese modulare Bauweise ermöglicht eine flexible Anpassung der Sensorgröße entlang der beiden Erstreckungsrichtungen beliebig zu erweitern. Somit können auch größere Objekte vermessen werden.

In einer weiteren Ausführungsform ist vorgesehen, dass Magnetsegmente in einem Randbereich der planaren Magnetanordnung ausgebildet sind, ein statisches Magnetfeld mit einer höheren magnetischen Feldstärke zu erzeugen als Magnetsegmente in einem mittleren Bereich der planaren Magnetanordnung. Hierdurch kann einer Abschwächung der Magnetfeldstärke entgegengewirkt werden, welche typischerweise in den Randbereichen der Magnetanordnung auftritt. Durch den Ausgleich der Feldinhomogenitäten zum Rand hin lässt sich somit eine homogene Feldstärke über das gesamte Nutzvolumen erreichen.

In einer weiteren Ausführungsform ist vorgesehen, dass die höhere magnetischen Feldstärke in dem Randbereich der planaren Magnetanordnung durch Magnetsegmente erreicht wird, welche eine höhere Magnetisierung und/oder eine größere vertikale Ausdehnung aufweisen, als Magnetsegmente in dem mittleren Bereich der planaren Magnetanordnung. Durch Verwenden von Magnetsegmenten höherer Magnetisierung im Randbereich der Magnetanordnung kann eine besonders flache Bauweise des Sensors erreicht werden. Hingegen können bei Verwendung von Magnetsegmenten mit einer größeren vertikalen Ausdehnung auch im mittleren Bereich der Magnetanordnung Magnetsegmente mit der maximalen Magnetisierung verwendet werden. Hierdurch kann insgesamt eine deutlich höhere Feldstärke im gesamten Nutzvolumen erreicht werden.

In einer weiteren Ausführungsform ist vorgesehen, dass in dem Randbereich der planaren Magnetanordnung mehrere übereinander angeordnete Magnetsegmente zum Erzielen der höheren magnetischen Feldstärke vorgesehen sind. Mit dieser Anordnung kann der Feldstärkeausgleich im Randbereich der planaren Magnetanordnung mithilfe von Standardmagneten realisiert werden. Damit lässt sich die Magnetfelderzeugungseinrichtung besonders einfach und kostengünstig aufbauen.

In einer weiteren Ausführungsform ist vorgesehen, dass wenigstens ein Teil der Magnetsegmente der planaren Magnetanordnung eine Ummantelung aus einem Kunststoff aufweist. Durch eine geschickte Wahl der Schichtdicke der Kunststoffummantelung auf jeder Seite des Magnetsegments lässt sich die Position des jeweiligen Magnetsegments innerhalb der planaren Magnetanordnung definieren. Insbesondere bei einer Anordnung mehrerer Magnetsegmente innerhalb einer Öffnung der Trägerplatte kann mittels der Dicke der Kunststoffummantelung die Distanz zwischen den einzelnen Magnetsegmenten genau eingestellt werden. Ferner ermöglicht die Kunststoffummantelung eine bessere Handhabbarkeit der Magnetsegmente, beim Ein- und Ausbau sowie den Transport des Sensors.

Ferner ist eine erfindungsgemäße Kernspinresonanzvorrichtung umfassend einen entsprechenden Sensor vorgesehen. Die Kernspinresonanzvorrichtung ist dabei ausgebildet, wenigstens eine Materialeigenschaft einer in einem Nutzvolumen angeordneten Materialprobe für mehrere Messschichten unabhängig voneinander zu bestimmen.

In einer Ausführungsform ist vorgesehen, dass die Kernspinresonanzvorrichtung eine Hubeinrichtung zum Einstellen des Abstands zwischen dem Sensor und einer im Nutzvolumen angeordneten Materialprobe umfasst. Die Hubeinrichtung umfasst dabei wenigsten einen elektrisch und/oder manuell angetriebenen Aktuator. Mit Hilfe einer solchen Hubeinrichtung lassen sich auf eine einfache Weise tiefenabhängige Messwerte generieren. Hierdurch kann ein genaues Tiefenprofil der vermessenen Materiaprobe erstellt werden.

In einer weiteren Ausführungsform ist vorgesehen, dass der Aktuator einen den Sensor tragenden ersten Aktuatorteil und einen dazu beweglich angeordneten zweiten Aktuatorteil mit einer Auflagefläche zum Auflegen auf eine zu der Materialprobe ortsfest angeordneten Auflagefläche umfasst. Hierdurch wird eine besonders einfache Bauweise erreicht.

In einer weiteren Ausführungsform ist vorgesehen, dass der erste Aktuatorteil in Form eines Elektromotors ausgebildet ist während der zweite Aktuatorteil in Form einer vom Elektromotor angetriebenen Spindel ausgebildet ist. Ein solcher Spindelantrieb erlaubt eine besonders präzise Verstellung der Höhe des Sensors.

In einer weiteren Ausführungsform ist vorgesehen, dass die Hubeinrichtung mehrere entlang des Umfangs des Sensors verteilt angeordnete Aktuatoren umfasst. Hierdurch wird eine besonders stabile und präzise Höhenverstellung ermöglicht.

Im Folgenden wird die Erfindung anhand von Figuren näher beschrieben. Dabei zeigen:
Fig. 1 einen Sensor für eine Kernspinresonanzvorrichtung umfassend eine Magnetfelderzeugungseinrichtung mit einer planaren Magnetanordnung und eine Messeinrichtung in einer schematischen Querschnittdarstellung;
Fig. 2 eine Draufsicht auf die Magnetfelderzeugungseinrichtung des Sensors mit der planaren Magnetanordnung aus Figur 1;
Fig. 3 eine schematische Seitenansicht der planaren Magnetanordnung mit elf nebeneinander angeordneten Magnetsegmenten mit jeweils um 45° verdrehten Magnetisierungsrichtungen;
Fig. 4 eine Seitenansicht einer planaren Magnetanordnung mit einem im Wesentlichen auf der Vordersite angeordneten Magnetfeld;
Fig. 5 eine Draufsicht schematisch auf die planare Magnetanordnung mit vier Magnetpolen und einer drei Wicklungen umfassenden elektrischen Spule;
Fig. 6 eine Draufsicht auf eine durch Strukturieren einer elektrisch leitfähigen Schicht erzeugten elektrischen Spule mit drei Entwicklungen;
Fig. 7 eine Seitenansicht der planaren Magnetanordnung aus Figur 4 und der in der elektrisch leitfähigen Schicht ausgebildeten elektrische Spule zur Verdeutlichung des von der elektrischen Spule erzeugten magnetischen Wechselfelds;
Fig. 8 eine Seitenansicht der planaren Magnetanordnung aus Figur 4 und der elektrischen Spule aus Figur 7 zur Verdeutlichung der Überlagerung der von der planaren Magnetanordnung und der elektrische Spule erzeugten Magnetfelder;
Fig. 9 eine Draufsicht auf einen Sensor mit einer drei nebeneinander angeordnete Magnetpole aufweisenden planaren Magnetanordnung und einer zwei nebeneinander angeordnete Wicklungen aufweisenden elektrischen Spule;
Fig. 10 eine Draufsicht auf einen Sensor mit einer vier nebeneinander angeordnete Magnetpole aufweisenden planaren Magnetanordnung und einer drei nebeneinander angeordnete Wicklungen aufweisenden elektrischen Spule;
Fig. 11 schematisch eine Draufsicht auf eine planare Magnetanordnung aus separaten Magnetsegmenten, welche in Form einer 11x11-Matrix angeordnet sind;
Fig. 12 schematisch eine Draufsicht auf eine planare Magnetanordnung aus insgesamt elf prismenförmigen Magnetsegmenten;
Fig. 13 schematisch eine Seitenansicht auf eine planare Magnetanordnung umfassend ein sich über die gesamte Breite erstreckendes Magnetsegment, welches Bereiche mit unterschiedlich orientierten Magnetisierung in aufweist;
Fig. 14 schematisch eine Querschnittansicht durch eine planare Magnetanordnung mit in zwei Ebenen übereinander angeordneten Trägerplatten mit Magnetsegmenten;
Fig. 15 schematisch eine Draufsicht die untere Trägerplatte zur Verdeutlichung der speziellen Anordnung der Magnetsegmente in der unteren Trägerplatte; und
Fig. 16 schematisch eine Seitenansicht auf eine Kernspinresonanzvorrichtung umfassend einen Sensor sowie eine Hubeinrichtung zum Einstellen der Entfernung zwischen dem Sensor und einer im Nutzvolumen angeordneten Materialprobe.

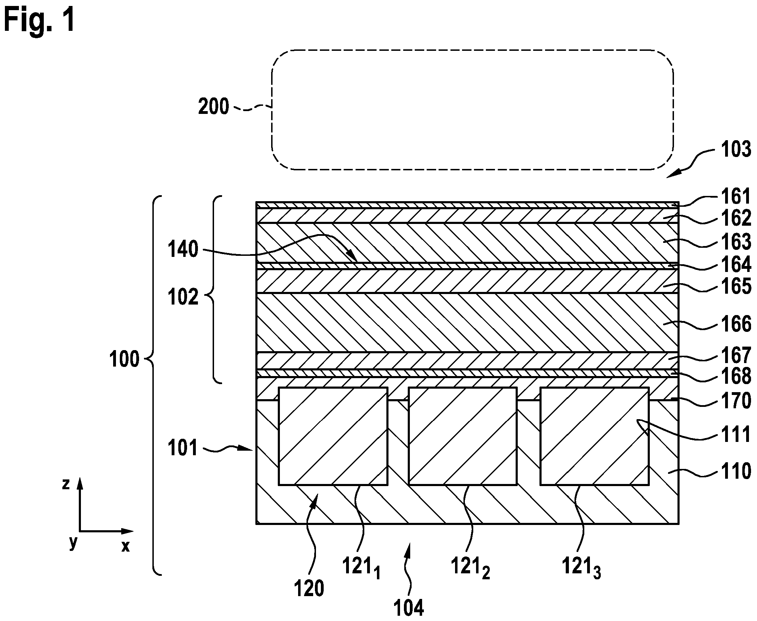

Der erfindungsgemäße Kernspinresonanz-Sensor zeichnet sich durch eine flache Bauweise aus, welche ein nach außen offenes Messsystem ermöglicht, das durch eine Aneinanderreihung mehrerer Sensoren zudem beliebig erweiterbar ist. Die flache Bauweise des Sensors wird dabei durch eine spezielle Anordnung von Permanentmagneten zum Erzeugen eines B0-Feldes und eine spezielle Anordnung wenigstens einer elektrischen Spule zum Erzeugen eines B1-Feldes erreicht. Hierzu zeigt die **Figur 1** schematisch einen Querschnitt durch einen solchen Kernspinresonanz-Sensor 100. Der Sensor 100 umfasst dabei eine Magnetfelderzeugungseinrichtung 101 zum Erzeugen eines statischen Magnetfelds (B0-Feld) in einem Nutzvolumen und eine zwischen der Magnetfelderzeugungseinrichtung 101 und dem Nutzvolumen 200 angeordnete Messeinrichtung 102 zum Erzeugen eines Anregungssignals (B1-Feld) in dem Nutzvolumen 200 und zum Messen des darauf folgenden Antwortsignals.

Die Magnetfelderzeugungseinrichtung 101 umfasst dabei eine planare Anordnung 120 aus mehreren in einer Ebene nebeneinander angeordneten Magnetsegmenten 121₁, 121₂, 121₃. Hierbei handelt es sich um Permanent- bzw. Dauermagnete, welche im vorliegenden Ausführungsbeispiel würfel- bzw. quaderförmig ausgebildet sind und somit quadratische Querschnitte aufweisen. Grundsätzlich können die Magnetsegmente 121₁, 121₂, 121₃ jedoch auch andere geeignete Formen aufweisen, zum Beispiel zylindrisch oder rund. Die Magnetfelderzeugungseinrichtung 101 umfasst ferner eine Trägerplatte 110, welche als Matrix zur Aufnahme der Magnetsegmente 121₁, 121₂, 121₃ dient. Hierzu weist die Trägerplatte 110 mehrere Öffnungen 111, in welchen jeweils ein Magnetsegment 121₁, 121₂, 121₃ angeordnet ist. Die Öffnungen 111 definieren dabei die Position und Ausrichtung der Magnetsegmente 121₁, 121₂, 121₃ zueinander. Alternativ hierzu ist es auch möglich mehrere Magnetsegmente innerhalb einer gemeinsamen Öffnung anzuordnen. In diesem Fall kann die Position und Ausrichtung der Magnetsegmente zueinander durch geeignete Distanzstrukturen bestimmt werden, welche zwischen den Magnetsegmenten angeordnet sind. Sofern die Magnetsegmente über eine Kunststoffummantelung verfügen, kann der gegenseitige Abstand der Magnetsegmente innerhalb der Magnetanordnung auch durch die Schichtdicke der Kunststoffummantelung festgelegt werden. Es ist ferner auch möglich die Magnetsegmente auch ohne einen Abstand unmittelbar nebeneinander anzuordnen.

Die spezielle Anordnung der Magnetsegmente innerhalb der Magnetanordnung 120 erzeugt ein magnetisches Feld mit definierten Eigenschaften innerhalb eines bestimmten Raumbereichs 200, welcher in der Figur 1 unmittelbar oberhalb des Sensors 100 angeordnet ist. Der Raumbereich 200 definiert dabei ein Nutzvolumen, welches durch eine besonders hohe NMR-Sensitivität charakterisiert ist. Insbesondere weisen die vom Sensor 100 erzeugten Magnetfelder bei geeigneter Wahl der Betriebsparameter eine besonders hohe Homogenität im Nutzvolumen 200 auf.

Wie die Figur 1 ferner zeigt, ist die Messeinrichtung 102 in Form eines mehrere Schichten 161, 162, 163, 164, 165, 166, 167, 168 umfassenden Schichtstapels ausgebildet. Dabei umfasst der Schichtstapel eine elektrisch leitfähige Schicht 164, welche vorzugsweise auf einem Trägersubstrat 165, vorzugsweise einer Leiterplatte, wie zum Beispiel PCB, angeordnet ist. Die elektrisch leitfähige Schicht 164 enthält dabei eine elektrische Spule 140 mit einer oder mehreren nebeneinander angeordneten Windungen (hier nicht gezeigt). Die elektrische Spule 140, welche im vorliegenden Ausführungsbeispiel durch Strukturierung der elektrisch leitfähigen Schicht 164 erzeugt wurde, bildet einen wesentlichen Bestandteil der Messeinrichtung 102. Im Betrieb des Sensors 100 erzeugt die elektrische Spule 140 ein magnetisches Wechselfeld (B1-Feld), welches sich im Nutzvolumen 200 mit dem Magnetfeld der planaren Magnetanordnung 120 im Wesentlichen orthogonal überlagert und als Anregungssignal für die Kernspinresonanzmessung dient. Die elektrische Spule 140 bildet vorzugsweise gleichzeitig auch eine Antenne zum Erfassen des auf das Anregungssignal folgenden Antwortsignals. Als Wechselfeld 150 beispielsweise ein gepulstes Magnetfeld dienen. Je nach Anwendung können jedoch auch andere zeitlich veränderliche elektromagnetische Felder als Anregungssignal (B1-Feld) verwendet werden.

Zusätzlich zur elektrischen Spule 140 kann die elektrisch leitfähige Schicht 164 auch wenigstens eine weitere elektrische Spule, insbesondere eine Shim-Spule, zur Korrektur des von der elektrischen Spule 140 erzeugten magnetischen Wechselfelds enthalten. Ferner können auch weitere passive und aktive Bauteile auf dem Trägersubstrat 165 angeordnet sein, vorzugsweise in den Randbereichen.

Um zu verhindern, dass die Messung durch externe elektromagnetische Wechselfelder unerwünscht beeinflusst wird, kann die Messeinrichtung 102 ferner eine äußere Abschirmstruktur umfassen. Die Abschirmstruktur kann dabei spezielle Strukturierung aufweisen, welche als Resonanzstrukturen zum Herausfiltern elektromagnetischer Strahlung bestimmter Frequenzen, wie zum Beispiel der Netzfrequenz (50 Hz) dienen. In der Figur 1 ist die äußere Abschirmstruktur in Form einer strukturierten metallischen Schicht 161 ausgebildet, welche beispielsweise Kupfer oder einem anderen nicht magnetischen Metall besteht. Die äußere Abschirmstruktur 161 ist dabei auf einem eigenen Trägersubstrat 162 angeordnet. Das Trägersubstrat 162 kann beispielsweise in Form einer Platine ausgebildet sein und eine relativ geringe Schichtdicke aufweisen, beispielsweise 1 mm aufweisen. Um den Abstand zwischen der elektrischen Spule 140 und der äußeren Abschirmstruktur 161 einzustellen, ist zwischen der elektrisch leitfähigen Schicht 164 und dem Trägersubstrat 162 ferner eine erste Trennschicht 163 mit definierter Schichtdicke vorgesehen. Die Schichtdicke beträgt weit vorzugsweise wenige Millimeter, beispielsweise 2 mm. Als Material für die erste Trennschicht 163 kann dabei jedes geeignete nicht magnetische Material verwendet werden, beispielsweise eine Acrylplatte.

Die Messeinrichtung 102 kann ferner eine innere Abschirmstruktur umfassen, welche die Magnetsegmente der planaren Magnetanordnung 120 vor dem magnetischen Wechselfeld der elektrischen Spule 140 abschirmt. Mit einer solchen inneren Abschirmstruktur kann verhindert werden, dass aufgrund des magnetischen Wechselfelds der elektrischen Spule 140 mechanische Kräfte auf die Magnetsegmente wirken, welche eine Verfälschung des Messsignals bewirken. In der Figur 1 ist die innere Abschirmstruktur in Form einer zwischen der elektrischen Spule 140 und den Magnetsegmenten der Magnetanordnung 120 angeordneten dünnen metallischen Schicht 168 ausgebildet. Als Material für die innere Abschirmstruktur 168 kommt dabei beispielsweise Kupfer oder ein anderes nicht magnetisches Metall infrage. Die innere Abschirmstruktur 168 kann dabei auf einer eigenen Substratschicht 167 angeordnet sein, welche vorzugsweise eine geringe Schichtdicke aufweist, beispielsweise 1 mm. Die Substratschicht 167 kann dabei aus jedem geeigneten Material, insbesondere einen nicht magnetischen Material, wie zum Beispiel Pappe oder Hartpapier bestehen. Ferner kann zwischen den beiden elektrisch leitfähigen Schichten 164, 168 eine zweite Trennschicht 166 vorgesehen sein, mit deren Hilfe sich der genaue Abstand zwischen der elektrischen Spule 140 und der inneren Abschirmstruktur 168 festlegen lässt. Die Schichtdicke dieser Trennschicht 166 beträgt vorzugsweise wenige Millimeter, zum Beispiel 2 mm. Die Trennschicht 166 kann dabei aus jedem geeigneten Material gebildet werden, beispielsweise ein nicht magnetisches Material.

Die in der Figur 1 gezeigte Messeinrichtung 102 umfasst insgesamt acht Schichten 161 - 168. Grundsätzlich ist es jedoch möglich durch Zusammenfassen der Substrat- und Trennschichten die Anzahl der Schichten und damit der notwendigen Herstellungsschritte zu reduzieren. So können beispielsweise die Substratschicht 162 und die Trennschicht 163 als eine gemeinsame Schicht ausgebildet sein. Auch die Trennschicht 166 kann mit der Substratschicht 165 und/oder mit der Substratschicht 167 eine gemeinsame Schicht bilden (hier nicht gezeigt).

Aufgrund des schichtförmigen Aufbaus und die geringen Schichtdicken der Schichten 161 - 168 weist die Messeinrichtung 102 eine relativ geringe Gesamthöhe auf, beispielsweise 10 mm.

Um einen definierten Abstand zwischen der planaren Magnetanordnung 120 und der Messeinrichtung 102 einzustellen, kann zwischen den beiden Komponenten eine weitere Trennschicht 170 vorgesehen sein. Die Trennschicht 71 besteht dabei vorzugsweise aus einem nicht magnetischen Material, wie zum Beispiel eine Acrylplatte. Im vorliegenden Ausführungsbeispiel weist die Acrylplatte 170 Vertiefungen auf, welche die aus der Trägerplatte 110 überstehenden Bereiche der Magnetsegmente 121₁, 121₂, 121₃ aufnimmt.

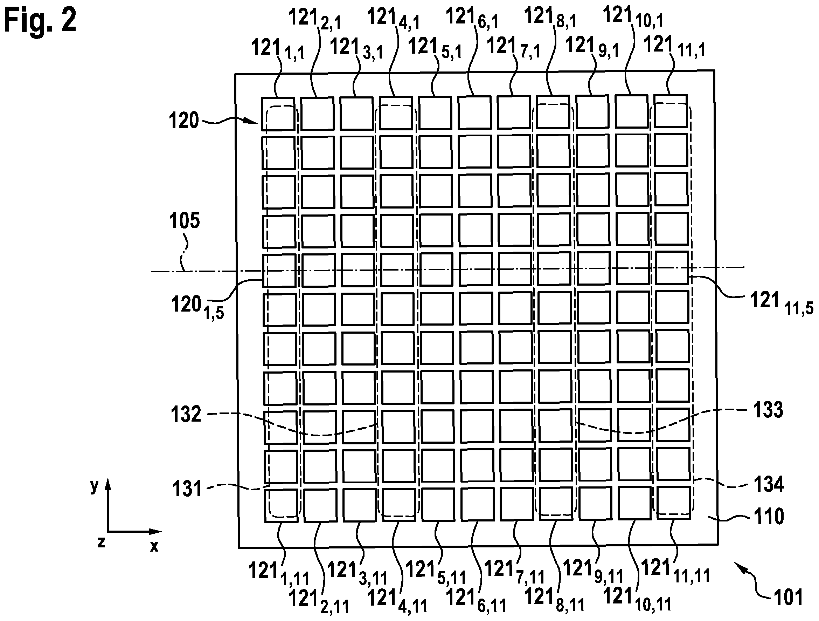

Die planare Magnetanordnung 120 umfasst erfindungsgemäß mehrere in einer Ebene nebeneinander angeordnete Magnetsegmente, deren Anzahl und räumliche Anordnung dabei abhängig von der jeweiligen Anwendung variieren kann. Die Figur 2 zeigt beispielhaft eine Draufsicht auf eine sich in der XY-Ebene erstreckende planare Magnetanordnung 120 mit insgesamt 121 innerhalb der Trägerplatte 110 angeordneten Magnetsegmenten 121_{1,1} - 121_{11,11}. Die Magnetsegmente 121_{1,1} - 121_{11,11} sind vorzugsweise gleichmäßig über den Trägerplatte 110 verteilt und bilden im vorliegendem Ausführungsbeispiel eine 11x11-Matrix mit 11 Zeilen und 11 Spalten. Dabei weisen die in der ersten Erstreckungsrichtung X der Magnetanordnung 120 unmittelbar nebeneinander angeordneten Magnetsegmente 121_{1,j} - 121_{11,j} (mit j= 1, 2, 3, ...11) jeweils unterschiedliche Magnetisierungsrichtungen auf, wodurch sich ein im Wesentlichen auf der Vorderseite 103 der planaren Magnetanordnung konzentriertes Magnetfeld mit mehreren Magnetpolen ergibt. Im Unterschied hierzu weisen die entlang einer zweiten Erstreckungsrichtung Y der planaren Magnetanordnung 120 nebeneinander angeordneten Magnetsegmente 121_{i,1} - 121_{i,11} (mit i= 1, 2, 3, ...11) einer Spalte rerfindungsgemäß die gleiche Magnetisierungsrichtung auf. Im vorliegenden Ausführungsbeispiel weist die planare Magnetanordnung 120 insgesamt vier Magnetpole 131, 132, 133, 134 mit jeweils alternierenden Magnetfeldrichtungen auf, welche in der Figur 2 mittels gestrichelten Linien angedeutet sind.

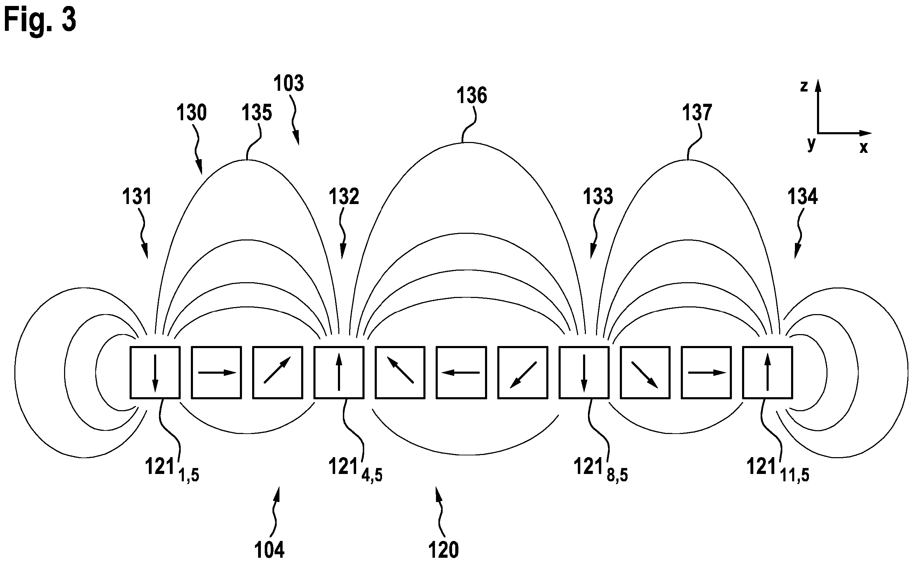

Zur Verdeutlichung zeigt die Figur 3 einen Querschnitt durch die planare Magnetanordnung 120 aus der Figur 2 entlang der Linie 105, wobei die Orientierungen der Magnetisierung der Magnetsegmente mittels entsprechender Pfeile dargestellt sind. Hierbei wird ersichtlich, dass die Magnetisierungsrichtungen von unmittelbar nebeneinander benachbarten Magnetsegmenten 121_{1,5} - 121_{11,5} jeweils um einen bestimmten Winkel zueinander verdreht sind. Durch die Drehung der Orientierung der Magnetisierung benachbarter Magnetsegmente wird eine spezielle Magnetanordnung erreicht, welche im Wesentlichen einem Halbach-Array entspricht. Eine solche Konfiguration von Permanentmagneten ermöglicht, dass sich der magnetische Fluss auf einer ersten Seite der Magnetanordnung fast aufhebt, während er auf der der ersten Seite gegenüber liegenden zweiten Seite verstärkt wird. Somit wird das magnetische Feld 130, welches in der Figur 3 schematisch mittels der Feldlinien angedeutet ist, hauptsächlich auf der dem Nutzvolumen 200 zugewandten Vorderseite 103 der planaren Magnetanordnung 120 konzentriert, während es auf der Rückseite 104 der planaren Magnetanordnung 120 relativ schwach ausgeprägt ist.

Im vorliegenden Ausführungsbeispiel beträgt der Drehwinkel für die Magnetsegmente 121_{2,5} - 121_{10,5} jeweils 45°. Lediglich die beiden am äußersten Rand der Magnetanordnung angeordneten Magnetsegmente 121_{1,5}, 121_{11,5} sind jeweils um 90° gegenüber ihren Nachbarn verdreht. Hierdurch werden mögliche Verzerrungen des statischen Magnetfelds 130 in dem Randbereich 127 der Magnetanordnung reduziert. Dabei kann der Drehwinkel zwischen benachbarten Magnetsegmenten grundsätzlich in Abhängigkeit der jeweiligen Anwendung variieren. Insbesondere kann bei Verwendung einer größeren Anzahl separater Magnetsegmente ein kleinerer Drehwinkel verwendet werden als bei einer kleineren Anzahl von Magnetsegmenten.

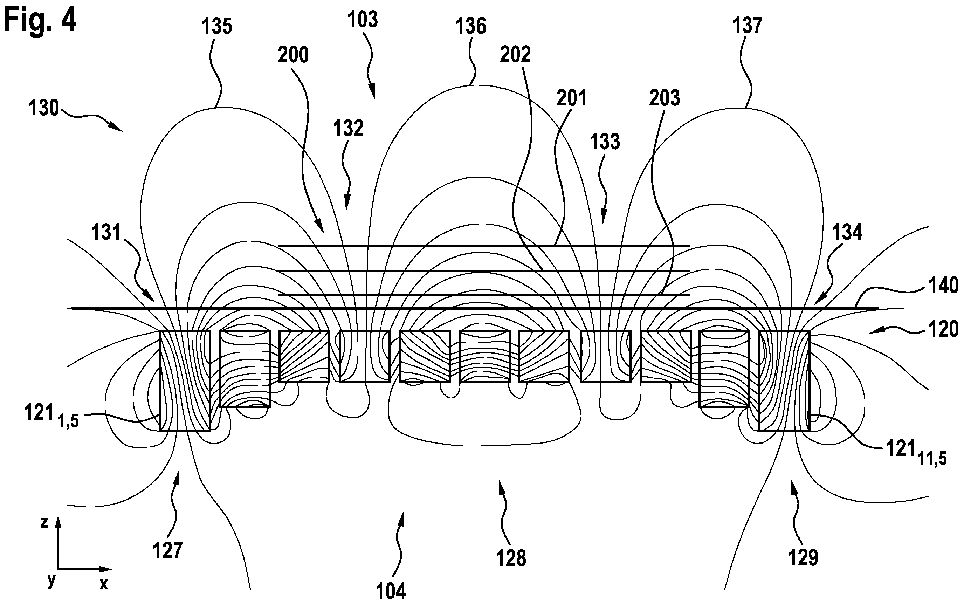

Um eine Abschwächung des statischen Magnetfelds 130 in den Randbereichen 127 der planaren Magnetanordnung 120 zu kompensieren, können in den entsprechenden Randbereichen 127 stärkere Magnetsegmente verwendet werden als in einem mittleren Bereich 128 der Magnetanordnung. Eine solche Verstärkung des Magnetfelds in den Randbereichen 127 lässt sich dabei beispielsweise mittels Magnetsegmenten entziehen, welche im Vergleich zu den Magnetsegmenten aus einem mittleren Bereich 128 der Magnetanordnung größer bzw. höher ausgebildet sind. Hierzu zeigt die **Figur 4** eine entsprechende planare Magnetanordnung 120 mit unterschiedlich hohen Magnetsegmenten 121_{1,5} - 121_{11,5}. Durch die Kompensation der Magnetfeldabschwächung in den Randbereichen 127 der Magnetanordnung 120 weisen die beiden äußeren Teilabschnitte 135, 137 des statischen Magnetfelds 130 ein im Wesentlichen gleiche stärker auf wie der mittlere Teilabschnitt 136 des statischen Magnetfelds 130. Hierdurch ergibt sich eine im wesentlichen homogene Feldstärke des statischen Magnetfelds 130 in den verschiedenen Messschichten des Nutzvolumens 200. Aus Übersichtlichkeitsgründen sind in der Figur 4 lediglich drei der das Nutzvolumen 200 definierenden Messschichten mittels der Linien 201, 202, 203 angedeutet. Wie hier dargestellt ist, befinden sich die Messschichten 201, 202, 203 vorzugsweise oberhalb der elektrischen Spule 140. Durch die in den Messschichten realisierte hohe Homogenität der Magnetfelder ist es möglich, verschiedene Atomkerne gleichzeitig zu messen. Dabei kann eine Unterscheidung der verschiedenen Atomkerne mittels der T1/T2 Relaxation erfolgen.

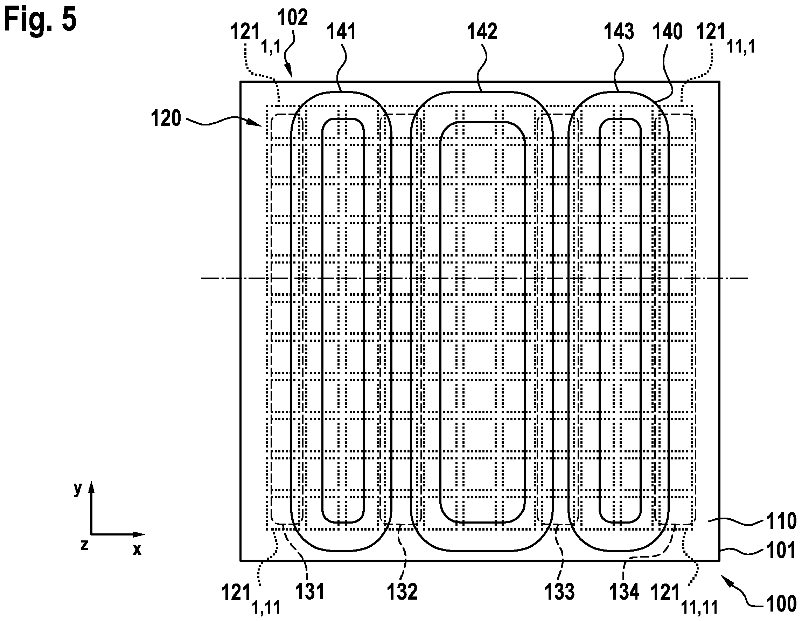

Eine Anordnung der elektrischen Spule 140 in Bezug auf die planare Magnetanordnung 120 ist in der **Figur 5** schematisch dargestellt. Hierbei wird ersichtlich, dass die elektrische Spule 140 im vorliegenden Ausführungsbeispiel insgesamt drei Wicklungen 141, 142, 143 umfasst. Dabei sind die Wicklungen bzw. die inneren Bereiche der Wicklungen jeweils zwischen zwei unmittelbar benachbarten Magnetpolen 131, 132, 133, 134 angeordnet.

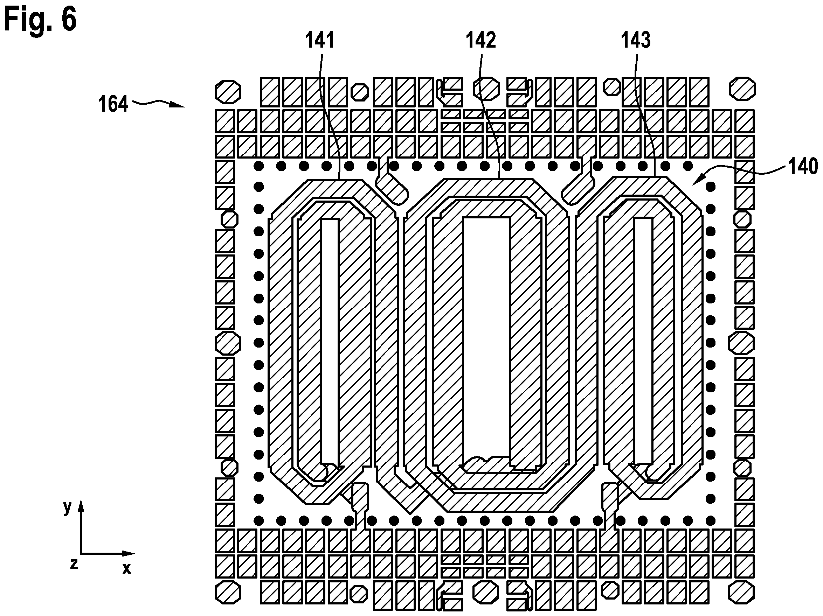

Die **Figur 6** zeigt ein mögliches Design einer elektrischen Spule 140 mit drei nebeneinander angeordneten Wicklungen 141, 142, 143, welche beispielhaft durch Strukturierung der elektrisch leitfähigen Schicht 164 erzeugt wurde. Die nebeneinander angeordneten Wicklungen 141, 142, 143 der in der Figur 6 gezeigten elektrischen Spule 140 sind dabei in Form von Teilspulen ausgebildet, wobei jede Teilspule im vorliegenden Fall zwei Wicklungen umfasst. Grundsätzlich kann die Anzahl der Wicklungen pro Teilspule je nach Anwendung variieren. Erfindungsgemäß ist die elektrische Spule 140 in Form einer multiresonanten Spule ausgebildet, mit deren Hilfe gleichzeitig Wechselfelder unterschiedlicher Frequenz emittiert bzw. detektiert werden können. Mithilfe einer multiresonanten Spule können verschiedene Schichten des Nutzvolumens 200 gleichzeitig vermessen werden. Die Unterscheidung der verschiedenen Schichten kann dabei mittels eines feldabhängigen Kontrasts erfolgen. Hierzu kann beispielsweise ein magnetfeldabhängiges Kontrastmittel verwendet werden.

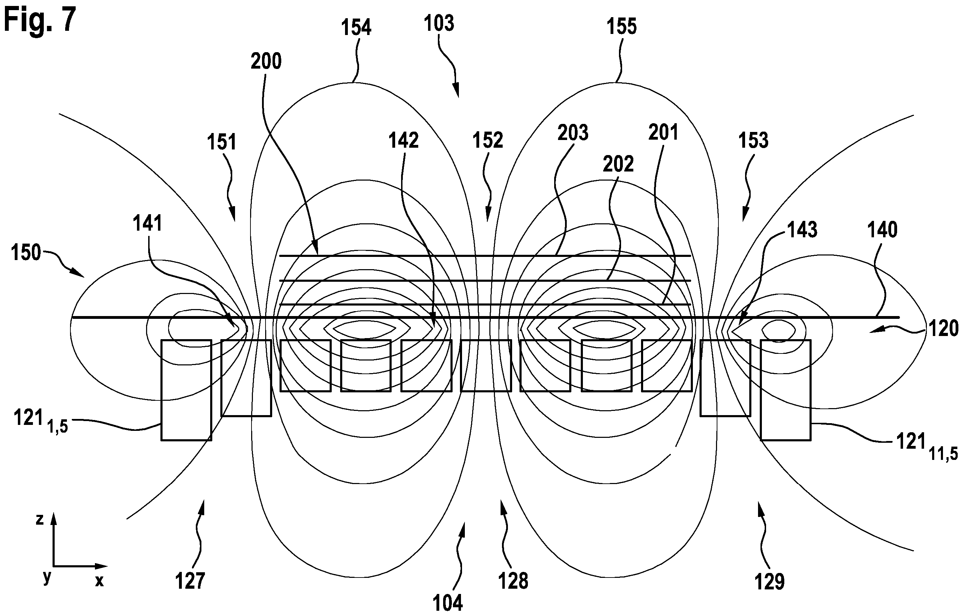

Die **Figur 7** zeigt eine der Anordnung, welche der Konfiguration aus der Figur 4 entspricht, wobei hier lediglich das magnetische Wechselfeld 150 der elektrischen Spule 140 dargestellt ist. Wie hierbei ersichtlich ist, weist das von den drei Teilspulen 141, 142, 143 im Betrieb erzeugte magnetische Wechselfeld 150 auf der dem Nutzvolumen 200 zugewandten Oberseite insgesamt drei Magnetpole 151, 152, 153 auf.

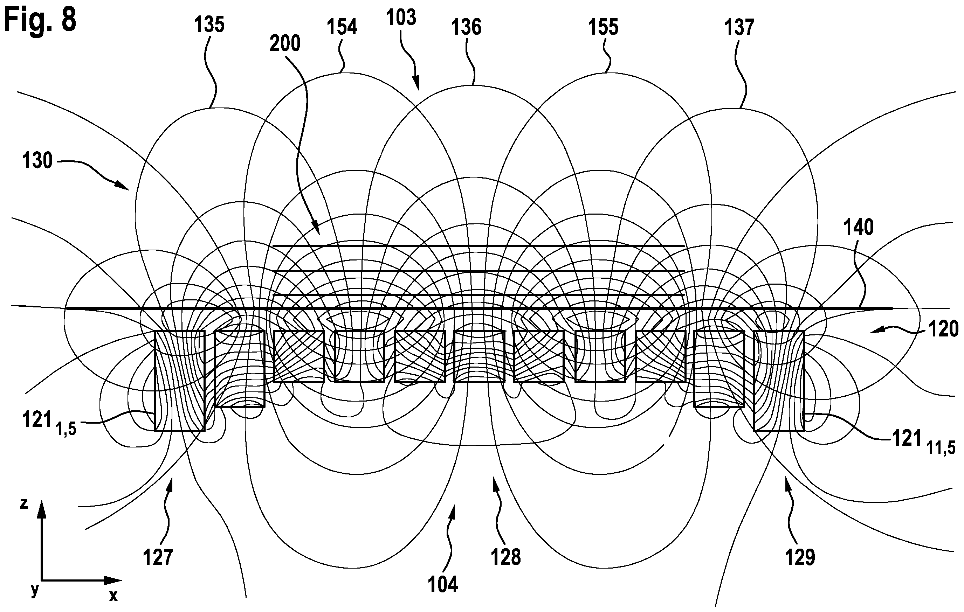

Die **Figur 8** zeigt eine Überlagerung des statischen Magnetfelds 130 aus Figur 4 und des magnetischen Wechselfelds 150 aus Figur 7. Hierbei wird ersichtlich, dass die beiden Magnetfelder 130, 150 jeweils zueinander versetzte Magnetpole aufweisen, wobei jeweils ein Magnetpol 151, 152, 153 des magnetischen Wechselfelds 150 im Wesentlichen zentral zwischen zwei unmittelbar benachbarten Magnetpolen 131, 132, 133, 134 des statischen Magnetfelds 130 angeordnet ist. Aufgrund dieser speziellen Anordnung ergibt sich, dass die Feldlinien der beiden Magnetfelder 130, 150 in dem durch die nutzbaren Messschichten 201, 202, 203 definierten Nutzvolumen 200 im Wesentlichen orthogonal zueinander verlaufen. Dabei kann durch eine entsprechende Anpassung der Betriebsparameter bzw. der Konfiguration eine für NMR-Messung optimierte Feldverteilung im Nutzvolumen 200 erzielt werden.

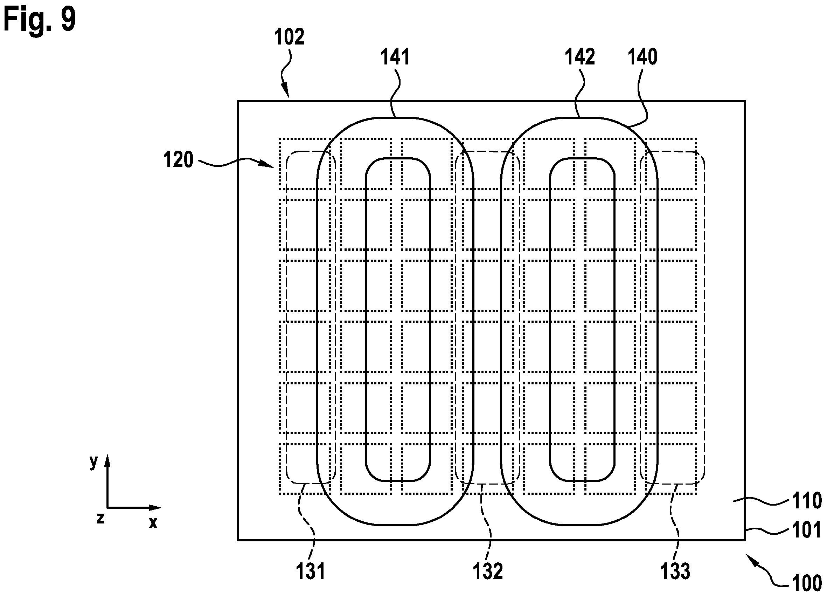

Grundsätzlich lässt sich der Sensor 100 auch in unterschiedlicher Größe herstellen. Dabei kann die Anzahl der verwendeten Magnetsegmente an die Anzahl der Teilspulen variieren. Hierzu zeigt die **Figur 9** eine verkleinerte Version des Sensors 100 aus der Figur 5. Der Sensor 100 weist eine planare Magnetanordnung 120 mit insgesamt 41 in einer 7x6-Matrix angeordneten 41 Magnetsegmenten auf. Das von der planaren Magnetanordnung 21 erzeugte Magnetfeld auf der Vorderseite lediglich drei Magnetpole 131, 132, 133 auf. Entsprechend weist die elektrische Spule 41 lediglich zwei Wicklungen bzw. Teilspulen 141, 142 auf.

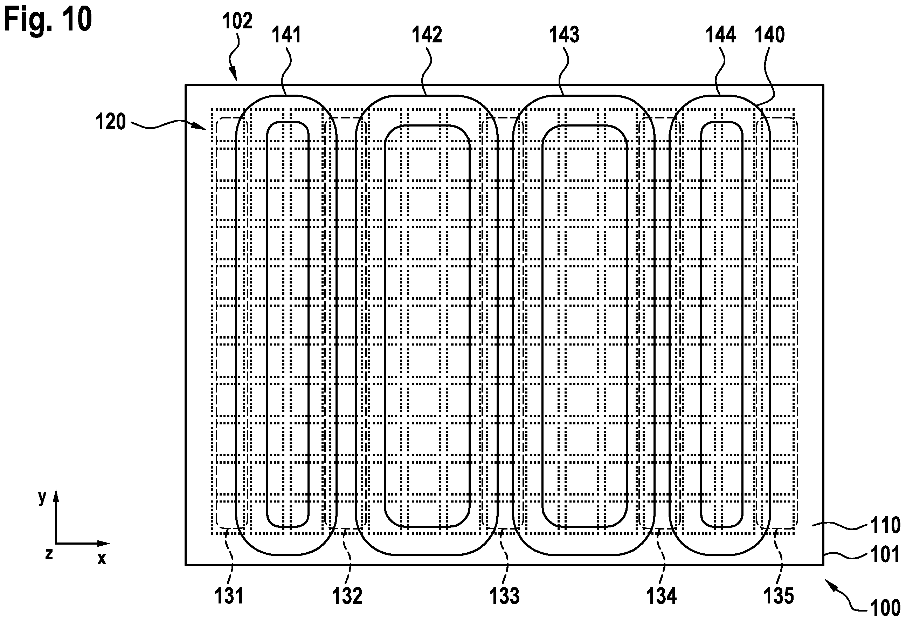

Im Unterschied hierzu zeigt die **Figur 10** eine vergrößerte Version des Sensors 100 aus der Figur 5. Der vergrößerte Sensor 100 weist eine planare Magnetanordnung 21 mit insgesamt 150 in einer 15x10-Matrix angeordneten Magnetsegmenten auf. Dabei weist das statische Magnetfeld auf der Vorderseite der planaren Magnetanordnung 120 insgesamt fünf Magnetpole 131, 132, 133, 134, 135 mit alternierender Feldrichtung auf. Entsprechend umfasst die elektrische Spule 41 insgesamt vier Wicklungen bzw. Teilspulen 141, 142, 143, 144.

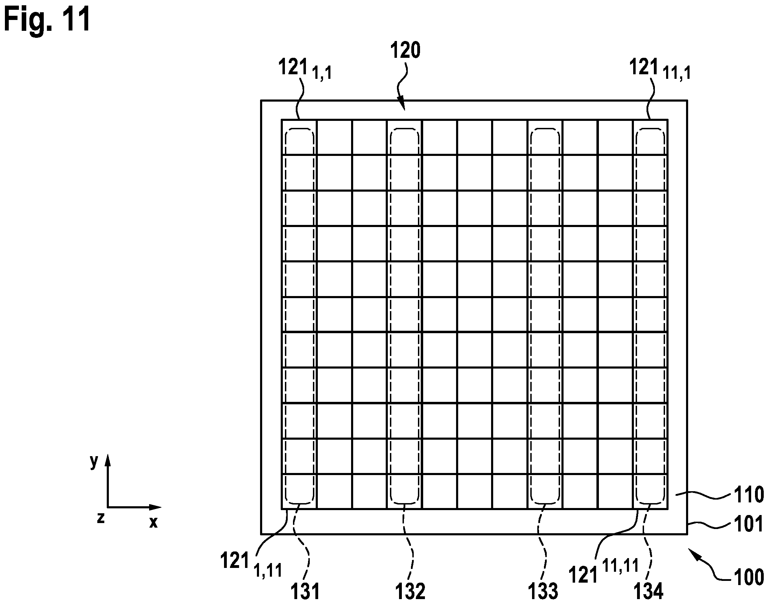

Grundsätzlich können die Magnetsegmente der planaren Magnetanordnung 120 auch lückenlos aneinander angeordnet werden. Hierzu zeigt die **Figur 11** eine entsprechende ausgebildete planare Magnetanordnung 120.

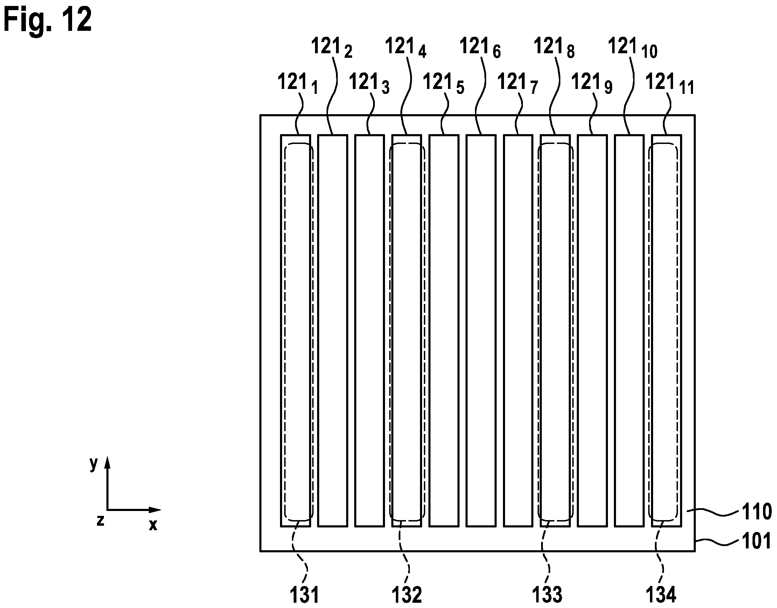

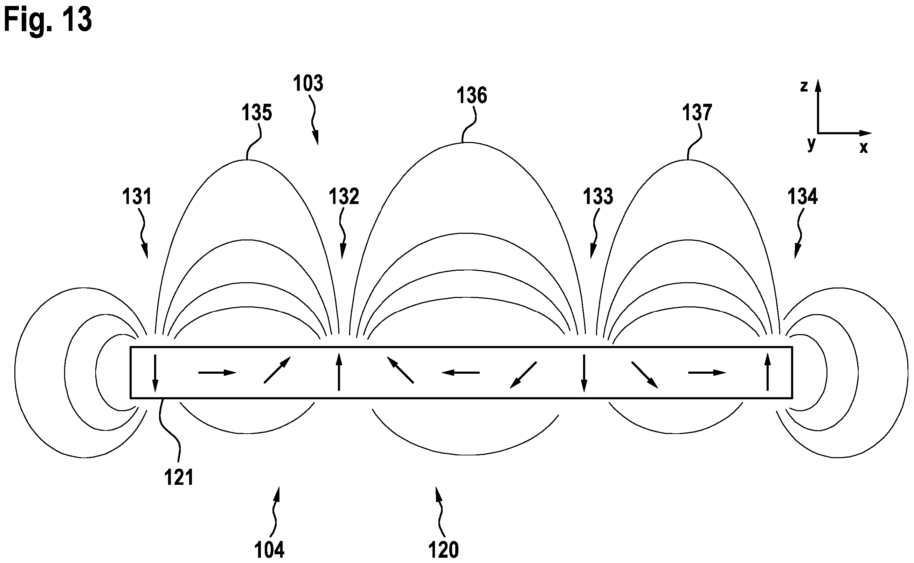

Neben einer matrixförmigen Anordnung der Magnetsegmente, welche beispielsweise in Figur 2 gezeigt ist, kann die planare Magnetanordnung grundsätzlich auch durch eine Aneinanderreihung länglicher Magnetsegmente erzeugt werden. Hierzu zeigt die **Figur 12** eine entsprechende planare Magnetanordnung 21, welche nicht in den durch die Ansprüche definierten Schutzumfang der Erfindung fällt und insgesamt elf in der ersten Erstreckungsrichtung X nebeneinander angeordnete balken- bzw. stabförmige Magnetsegmente umfasst. Grundsätzlich ist es möglich Magnetsegmente zu verwenden, welche eine komplexe Magnetisierung aufweisen. Hierzu zeigt die **Figur 13** eine planare Magnetanordnung 120 mit einem einzelnen Magnetsegment 121, welche nicht in den durch die Ansprüche definierten Schutzumfang der Erfindung fällt und Abschnitte unterschiedlicher Magnetisierungsrichtung aufweist. Insbesondere weisen unmittelbar benachbarte Abschnitte des Magnetsegments 121 jeweils um einen bestimmten Winkel verdrehte Magnetisierungsrichtungen auf. Ein solcher Permanentmagnet kann beispielsweise durch Sintern erzeugt werden.

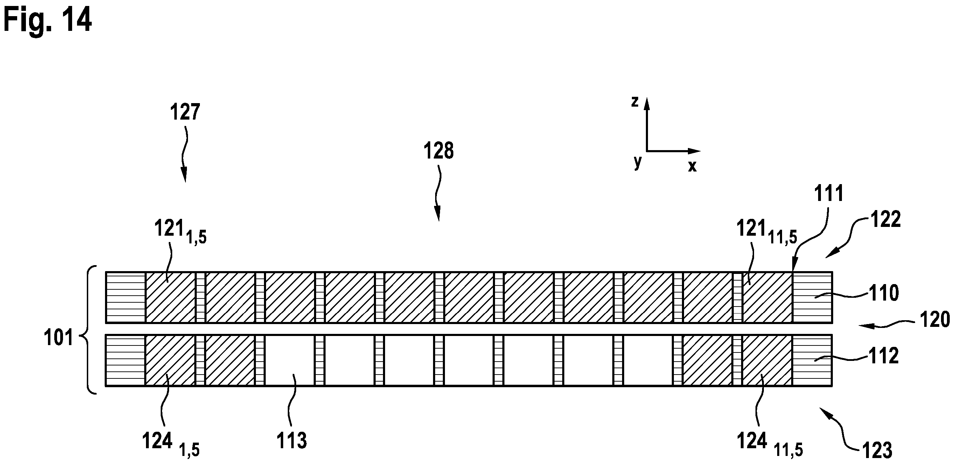

Um eine Kompensation der Magnetfeldabschwächung in den Randbereichen 127 der planaren Magnetanordnung 120 zu erzielen, kann alternativ zu der im Zusammenhang mit der Figur 4 beschriebenen Verwendung unterschiedlich großer Magnetsegmente auch eine dreidimensionale Anordnung von Magnetsegmenten verwendet werden. Hierzu zeigt die **Figur 14** eine Querschnittdarstellung durch eine in die Z-Richtung entsprechend erweiterte planare Magnetanordnung 120. Die Magnetsegmente sind dabei in zwei übereinanderliegenden Ebenen 122, 123 angeordnet. Hierzu umfasst die Magnetisierungseinrichtung 101 eine zusätzliche Trägerplatte 112, welche unterhalb der ersten Trägerplatte 110 befestigt wird. Die zweite Trägerplatte 112 weist dabei lediglich in ihren Randbereichen 127 Magnetsegmente 124_{1,5} - 124_{11,5} auf. Im mittleren Bereich 128 der zweiten Trägerplatte 112 sind hingegen keine Magnetsegmente vorhanden. Durch die Überlagerung der Magnetfelder der in den Randbereichen 121 der Magnetanordnung übereinander angeordneten Magnetsegmente ergibt sich die gewünschte Verstärkung des statischen Magnetfelds 130 den Randbereichen 127.

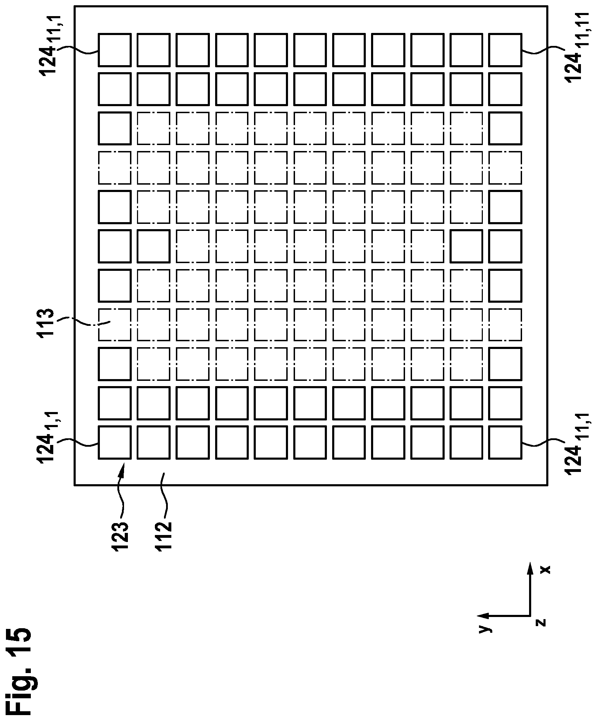

Die **Figur 15** zeigt eine Draufsicht auf die zusätzliche Trägerplatte 112 aus Figur 14. Hierbei wird ersichtlich, dass die zusätzliche Trägerplatte 112 ferner auch in einem in X-Richtung mittleren Bereich zusätzliche Magnetsegmente 124_{1,1} - 121_{11,11} aufweist. Zur besseren Veranschaulichung der Verteilung der Magnetsegmente 124_{1,1} - 121_{11,11} innerhalb der Trägerplatte 112 sind die Öffnungen 113 der Trägerplatte 112, in denen sich kein entsprechendes Magnetsegment befindet, mit einer Strich-Punkt-Linie dargestellt.

Grundsätzlich kann durch Hinzufügen bzw. Entfernen von Magnetsegmenten aus den Öffnungen 113 der unteren Trägerplatte 112 das statische Magnetfeld 130 der Magnetfelderzeugungseinrichtung 101 in gewünschter Weise modifiziert werden. Ferner ist es auch möglich, die Magnetsegmente in mehr als zwei Ebenen übereinander anzuordnen.

Die Verwendung einer Trägerplatte mit herausnehmbaren Magneten ermöglicht ein relativ einfaches Ändern der Magnetanordnung. Hierdurch kann die planare Magnetanordnung grundsätzlich an die jeweilige Anwendung angepasst werden. Ferner kann das statische Magnetfeld (B0-Feld) durch Drehen einzelner Magnetsegmente innerhalb der Trägerplatte für den Transport oder Lagerung des Sensors bedämpft oder sogar nahezu vollständig kompensiert werden. Eine analoge Reduktion des Magnetfelds kann durch Vertauschen der Position einzelner Magnetsegmente innerhalb der Trägerplatte erzielt werden.

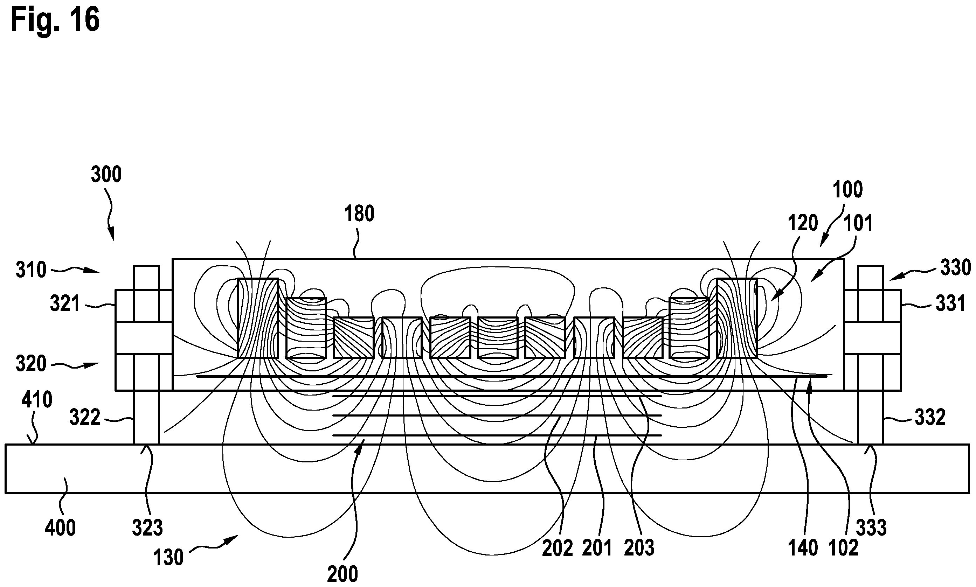

Die **Figur 16** zeigt beispielhaft eine auf einer Bodenplatte 400 angeordnete Kernspinresonanzvorrichtung 300. Die Kernspinresonanzvorrichtung 300 umfasst dabei einen innerhalb eines Gehäuses 180 angeordneten Sensor 100, ein den Sensor 100 aufnehmendes Gehäuse 180 sowie eine am Gehäuse angeordnete mechanische Hubeinrichtung 310 zum Einstellen des Abstands zwischen dem Sensor 100 und einer darunter angeordneten Materialprobe. Der im Wesentlichen analog zu dem Sensor aus der Figur 4 aufgebaute Sensor 100 umfasst dabei eine Magnetfelderzeugungseinrichtung 101 mit einer Magnetanordnung 120 zum Erzeugen eines statischen Magnetfelds 130 und eine Messeinrichtung 102 mit einer elektrischen Spule 140 zum Erzeugen eines magnetischen Wechselfelds 150. Im vorliegenden Beispiel ist der Sensor 100 jedoch um 180° gedreht angeordnet, so dass sich das von der Magnetanordnung 120 erzeugte statische Magnetfeld 130 nach unten in die Bodenplatte 400 hinein erstreckt. Entsprechend sind auch das Nutzvolumen 200 und die darin enthaltenen Messschichten 201, 202, 203 unterhalb des Sensors 100 angeordnet. In dieser Anordnung kann die Kernspinresonanzvorrichtung 300 bestimmte Materialeigenschaften der Bodenplatte 400 bestimmen, welche im vorliegenden Beispiel als Materialprobe dient. Grundsätzlich lassen sich damit jedoch auch Materialproben vermessen, welche auf bzw. unter der Bodenplatte 400 oder innerhalb der Bodenplatte 400 angeordnet sind.

Die mechanische Hubeinrichtung 310 umfasst einen oder mehrere manuell oder elektrisch betriebene Aktuatoren 320, 330, welche vorzugsweise entlang des Außenumfangs des Gehäuses 180 verteilt angeordnet sind. Insbesondere können vier jeweils an den Ecken des Gehäuses 180 angeordnete Aktuatoren vorgesehen sein. In der Figur 16 sind insgesamt zwei Aktuatoren 320, 330 dargestellt, welche an zwei gegenüberliegenden Seiten des Gehäuses 180 angeordnet sind. Die Aktuatoren 320, 330 sind im vorliegendem Ausführungsbeispiel an der Außenseite des Gehäuses 180 angeordnet. Alternativ hierzu können die Aktuatoren 320, 330 jedoch auch innerhalb des Gehäuses 180 angeordnet sein (hier nicht gezeigt). Die Aktuatoren 320, 330 umfassen jeweils einen mit dem Gehäuse 180 verbundenen ersten Aktuatorteil 321 und einen dazu jeweils beweglichen zweiten Aktuatorteil 322, 332, welcher mit einer Auflagefläche 323, 333 auf der Oberfläche 410 der als Materialprobe dienenden Bodenplatte 400 aufliegt. Die Aktuatoren 320, 330 sind im vorliegenden Beispiel in Form von elektrischen Antrieben ausgebildet. Der zweite Aktuatorteil 322, 332 bildet dabei jeweils einen Elektromotor während der erste Aktuatorteil 321, 331 in Form einer durch den Elektromotor angetriebenen Spindel ausgebildet ist. Eine solche Bauweise ermöglicht eine besonders feine und genaue Verstellung. Im Betrieb der Aktuatoreinrichtung 300 wird der erste Aktuatorteil 321, 331 gegenüber dem jeweils zweiten Aktuatorteil 322, 332 verschoben. Durch eine koordinierte Bewegung aller Aktuatoren entsteht eine gewünschte Hubbewegung des Sensors 100 gegenüber der Bodenplatte 400. Aus diesem Grund können mithilfe der Hubeinrichtung 300 auf eine relativ einfache Weise tiefenabhängige Messwerte generiert werden, mit deren Hilfe ein Tiefenprofil der Bodenplatte 400 bzw. einer mit der Bodenplatte 400 ortsfest verbundenen Materialprobe erzeugt werden kann.

Die Hubvorrichtung wird vorzugsweise mittels einer geeigneten Steuereinrichtung gesteuert. Diese Steuereinrichtung kann beispielsweise integraler Bestandteil der Steuer- und Auswerteeinrichtung der Kernspinresonanzvorrichtung sein. Darüber hinaus ist jedoch auch eine autark arbeitende Steuereinrichtung zur Steuerung der Hubbewegung des Sensors 100 möglich.

Neben den hier gezeigten Elektromotoren mit Spindeln kommen grundsätzlich alle geeigneten mechanischen Einrichtungen als Aktuator für die Höhenverstellung des Sensors 100 in Frage. Unter anderem können auch manuell betriebene Aktuatoren zum Einsatz kommen, welche beispielsweise eine manuelle Einrastung mit vordefinierten Abständen aufweisen.

Aus Gründen der Übersichtlichkeit sind in der Figur 16 weitere Komponenten der Kernspinresonanzvorrichtung 300, wie z.B. die Steuer- und Auswerteeinrichtung oder die Energieversorgungseinrichtung, nicht gezeigt.

Die Kernspinresonanzvorrichtung kann einen oder mehrere der hier beschriebenen NMR-Sensoren umfassen. Eine typische Kernspinresonanzvorrichtung umfasst ferner auch weitere Komponenten, wie z.B. eine Steuer- und Auswerteeinrichtung und eine Energieversorgungseinrichtung.

Obwohl die Erfindung vorwiegend anhand von konkreten Ausführungsbeispielen beschrieben wurde, ist sie keineswegs darauf beschränkt. Der Fachmann wird somit die beschriebenen Merkmale geeignet abändern und miteinander kombinieren können, sofern der hierdurch erhaltene Gegenstand in den durch die Ansprüche definierten Schutzumfang der Erfindung fällt. Insbesondere können die hier jeweils separat beschriebenen Methoden zur lokalen Modifikation der magnetischen Eigenschaften der Korrekturschicht auch beliebig miteinander kombiniert werden.

## Patentansprüche

1. Sensor (100) für eine Kernspinresonanzvorrichtung (300) zum Bestimmen wenigstens einer Materialeigenschaft einer in einem Nutzvolumen (200) angeordneten Materialprobe umfassend:
- eine Magnetfelderzeugungseinrichtung (101) umfassend eine planare Magnetanordnung (120) zum Erzeugen eines statischen Magnetfelds (130, 135, 136, 137) in dem Nutzvolumen (200), wobei die planare Magnetanordnung (120) auf einer dem Nutzvolumen (200) zugewandten Vorderseite (103) mehrere magnetische Pole (131, 132, 133, 134) aufweist, welche entlang einer ersten Erstreckungsrichtung (X) der planaren Magnetanordnung (120) mit jeweils alternierender Ausrichtung nebeneinander angeordnet sind, und
- eine Messeinrichtung (102) zum Messen eines auf Kernspinresonanz der im Nutzvolumen (200) angeordneten Materialprobe basierenden Signals umfassend eine elektrische Spule (140) mit wenigstens einer Wicklung (141, 142, 143, 144) zum Erzeugen eines magnetischen Wechselfelds (150, 154, 155) in dem Nutzvolumen (200), wobei die Wicklung (141, 142, 143, 144) zwischen zwei unmittelbar benachbarten magnetischen Polen (131, 132, 133, 134) der planaren Magnetanordnung (120) angeordnet ist, so dass sich das magnetische Wechselfeld (150, 154, 155) der elektrischen Spule (140) im gesamten Nutzvolumen (200) im Wesentlichen orthogonal mit dem statischen Magnetfeld (130, 135, 136, 137) der planaren Magnetanordnung (120) überlagert, wobei die planare Magnetanordnung (120) entlang der ersten Erstreckungsrichtung (X) und entlang einer zweiten Erstreckungsrichtung (Y), die senkrecht zur ersten Erstreckungsrichtung (X) verläuft, jeweils mehrere nebeneinander angeordnete Magnetsegmente (121_{i,j}) mit jeweils orthogonal zur zweiten Erstreckungsrichtung (Y) der planaren Magnetanordnung (120) ausgerichteten Magnetisierungsrichtungen umfasst, und wobei Magnetsegmente (121_{i,j}), welche entlang der ersten Erstreckungsrichtung (X) der planaren Magnetanordnung (120) unmittelbar nebeneinander angeordnet sind, jeweils relativ zueinander verdrehte Magnetisierungsrichtungen aufweisen, wodurch auf der Vorderseite (103) der planaren Magnetanordnung (120) ein wesentlich stärkeres statisches Magnetfeld (130) erzeugt wird als auf der Rückseite (104) der planaren Magnetanordnung (120), wobei die entlang der zweiten Erstreckungsrichtung (Y) der planaren Magnetanordnung (120) nebeneinander angeordneten Magnetsegmente (121_{i,j}) eine gleiche Magnetisierungsrichtung aufweisen, wobei die elektrische Spule (140) in Form einer multiresonanten Spule ausgebildet ist.

2. Sensor (100) nach Anspruch 1,
wobei entlang der ersten Erstreckungsrichtung (X) der planaren Magnetanordnung (120) unmittelbar nebeneinander angeordnete Magnetsegmente (121_{i,j}) jeweils um 45° zueinander verdrehte Magnetisierungsrichtungen aufweisen.

3. Sensor (100) nach einem der Ansprüche 1 bis 2,
wobei die elektrische Spule (140) ferner zum Messen eines auf Kernspinresonanz der im Nutzvolumen (200) angeordneten Materialprobe basierenden Signals ausgebildet ist.

4. Sensor (100) nach einem der vorhergehenden Ansprüche,
wobei die elektrische Spule (140) auf der Vorderseite (103) der planaren Magnetanordnung (120) angeordnet ist.

5. Sensor (100) nach einem der vorhergehenden Ansprüche,
wobei die elektrische Spule (140) in Form einer strukturierten elektrisch leitfähigen Schicht (164) ausgebildet ist.

6. Sensor (100) nach Anspruch 5,
wobei in der elektrisch leitfähigen Schicht (164) ferner wenigstens eine Shim-Spule zur Homogenisierung des von der planaren Magnetanordnung (120) im Nutzvolumen (200) erzeugten statischen Magnetfelds (130) ausgebildet ist.

7. Sensor (100) nach einem der vorhergehenden Ansprüche,
wobei auf der Vorderseite (103) der planaren Magnetanordnung (120) vier magnetische Pole (131, 132, 133, 134) mit jeweils alternierenden Ausrichtungen ausgebildet sind, und
wobei die elektrische Spule (140) der Messeinrichtung (102) drei nebeneinander angeordnete Wicklungen (151, 152, 153) umfasst, deren magnetische Pole (151, 152, 153) jeweils zwischen zwei unmittelbar benachbarten magnetischen Polen (131, 132, 133, 134) der planaren Magnetanordnung (120) angeordnet sind.

8. Sensor (100) nach einem der vorhergehenden Ansprüche,
wobei zwischen der elektrischen Spule (140) und der planaren Magnetanordnung (120) eine innere Abschirmstruktur (161) aus einem elektrisch leitfähigen Material mit einer hohen magnetischen Permeabilität angeordnet ist, welche den Magnetsegmenten (121_{i,j}) als Abschirmung vor dem magnetischen Wechselfeld (150, 154, 155) der elektrischen Spule (140) dient.

9. Sensor (100) nach einem der vorhergehenden Ansprüche,
wobei zwischen der elektrischen Spule (140) und dem Nutzvolumen (200) eine äußere Abschirmstruktur (168) aus einem elektrisch leitfähigem Material mit einer hohen magnetischen Permeabilität angeordnet ist, welche der elektrischen Spule (140) als Abschirmung gegen elektromagnetische Störfelder dient.

10. Sensor (100) nach Anspruch 9,
wobei die äußere Abschirmstruktur (168) Resonanzstrukturen aufweist, welche zur gezielten Abschirmung elektromagnetischer Störfelder mit Frequenzen im Bereich der Netzfrequenz dienen.

11. Sensor (100) nach einem der vorhergehenden Ansprüche,
wobei die Magnetfelderzeugungseinrichtung (101) eine Trägerplatte (130) aus einem nichtmagnetischen Material umfasst, und wobei die Magnetsegmente (121_{i,j}) in wenigstens einer Öffnung (111) der Trägerplatte (110) eingebracht sind.

12. Sensor (100) nach Anspruch 11,
wobei wenigstens ein Teil der Magnetsegmente (121_{i,j}) der Magnetanordnung (120) drehbar innerhalb der Trägerplatte (110) ausgebildet ist.

13. Sensor (100) nach Anspruch 11 oder 12,
wobei die Magnetfelderzeugungseinrichtung (101) durch Nebeneinanderanordnung mehrerer Trägerplatten (110, 112) in wenigstens einer der beiden Erstreckungsrichtungen (X, Y) der planaren Magnetanordnung (120) modular erweiterbar ist.

14. Sensor (100) nach einem der vorhergehenden Ansprüche,
wobei Magnetsegmente (121_{i,j}) in einem Randbereich (127) der planaren Magnetanordnung (120) ausgebildet sind, ein statisches Magnetfeld mit einer höheren magnetischen Feldstärke zu erzeugen als Magnetsegmente (121_{i,j}) in einem mittleren Bereich (128) der planaren Magnetanordnung (120).

15. Sensor (100) nach Anspruch 14,
wobei die höhere magnetischen Feldstärke in dem Randbereich (127) der planaren Magnetanordnung (120) durch Magnetsegmente (121_{i,j}) erreicht wird, welche eine höhere Magnetisierung und/oder eine größere vertikale Ausdehnung aufweisen, als Magnetsegmente (121_{i,j}) in dem mittleren Bereich (128) der planaren Magnetanordnung (120).

16. Sensor (100) nach Anspruch 14 oder 15,
wobei in dem Randbereich (127) der planaren Magnetanordnung (120) mehrere übereinander angeordnete Magnetsegmente (121_{i,j}, 124_{i,j}) zum Erzielen der höheren magnetischen Feldstärke vorgesehen sind.

17. Sensor (100) nach einem der vorhergehenden Ansprüche,
wobei wenigstens ein Teil der Magnetsegmente (121_{i,j}) der planaren Magnetanordnung (120) eine Ummantelung aus einem Kunststoff aufweist.

18. Kernspinresonanzvorrichtung (300) umfassend einen Sensor (100) nach einem der vorhergehenden Ansprüche 1 bis 17,
wobei die Kernspinresonanzvorrichtung (300) ausgebildet ist, wenigstens eine Materialeigenschaft einer in einem Nutzvolumen (200) angeordneten Materialprobe für mehrere Messschichten (201, 202, 203) unabhängig voneinander zu bestimmen.

19. Kernspinresonanzvorrichtung (300) nach Anspruch 18,
wobei die Kernspinresonanzvorrichtung (200) eine Hubeinrichtung (310) mit wenigstens einem elektrisch und/oder manuell angetriebenen Aktuator (320, 330) zum Einstellen des Abstands zwischen dem Sensor (100) und einer im Nutzvolumen (200) angeordneten Materialprobe umfasst.

20. Kernspinresonanzvorrichtung (300) nach Anspruch 19,
wobei der Aktuator (320, 330) einen den Sensor (100) tragenden ersten Aktuatorteil (321, 331) und einen dazu beweglich angeordneten zweiten Aktuatorteil (322, 332) mit einer Auflagefläche (323, 333) zum Auflegen auf eine zu der Materialprobe ortsfest angeordneten Oberfläche (410) umfasst.

21. Kernspinresonanzvorrichtung (300) nach Anspruch 20,
wobei der erste Aktuatorteil (321, 331) in Form eines Elektromotors ausgebildet ist, und
wobei der zweite Aktuatorteil (322, 332) in Form einer vom Elektromotor angetriebenen Spindel ausgebildet ist.

22. Kernspinresonanzvorrichtung (300) nach Anspruch 20,
wobei die Hubeinrichtung (310) mehrere entlang des Umfangs des Sensors (100) verteilt angeordnete Aktuatoren (320, 330) umfasst.

## Claims

1. Sensor (100) for a nuclear magnetic resonance apparatus (300) for determining at least one material property of a material sample arranged in a useful volume (200), comprising:
- a magnetic field generating device (101) comprising a planar magnetic arrangement (120) for generating a static magnetic field (130, 135, 136, 137) in the useful volume (200), wherein the planar magnetic arrangement (120) on a front side (103) facing the useful volume (200) has a plurality of magnetic poles (131, 132, 133, 134) which are arranged next to each other with respectively alternating orientation along a first direction of extent (X) of the planar magnetic arrangement (120), and
- a measuring device (102) for measuring a signal based on nuclear magnetic resonance of the material sample arranged in the useful volume (200), comprising an electric coil (140) having at least one winding (141, 142, 143, 144) for generating an alternating magnetic field (150, 154, 155) in the useful volume (200), wherein the winding (141, 142, 143, 144) is arranged between two directly adjacent magnetic poles (131, 132, 133, 134) of the planar magnetic arrangement (120) so that the alternating magnetic field (150, 154, 155) of the electric coil (140) overlaps with the static magnetic field (130, 135, 136, 137) of the planar magnetic arrangement (120) substantially orthogonally in the entire useful volume (200), wherein the planar magnetic arrangement (120), along the first direction of extent (X) and along a second direction of extent (Y) which runs perpendicular to the first direction of extent (X), in each case comprises a plurality of magnetic segments (121_{i,j}) arranged next to each other and each having magnetization directions oriented orthogonal to the second direction of extent (Y) of the planar magnetic arrangement (120), and wherein magnetic segments (121_{i,j}) which are arranged directly next to each other along the first direction of extent (X) of the planar magnetic arrangement (120) each have magnetization directions which are twisted relative to each other, as a result of which a substantially stronger static magnetic field (130) is generated on the front side (103) of the planar magnetic arrangement (120) than on the back side (104) of the planar magnetic arrangement (120), wherein the magnetic segments (121_{i,j}) arranged next to each other along the second direction of extent (Y) of the planar magnetic arrangement (120) have the same magnetization direction, wherein the electric coil (140) is designed in the form of a multi-resonant coil.

2. Sensor (100) according to Claim 1,
wherein magnetic segments (121_{i,j}) arranged directly next to each other along the first direction of extent (X) of the planar magnetic arrangement (120) each have magnetization directions twisted by 45° to each other.

3. Sensor (100) according to either of Claims 1 and 2,
wherein the electric coil (140) is further designed to measure a signal based on nuclear magnetic resonance of the material sample arranged in the useful volume (200).

4. Sensor (100) according to one of the preceding claims,
wherein the electric coil (140) is arranged on the front side (103) of the planar magnetic arrangement (120).

5. Sensor (100) according to one of the preceding claims,
wherein the electric coil (140) is designed in the form of a structured electrically conductive layer (164).

6. Sensor (100) according to Claim 5,
wherein at least one shim coil for homogenizing the static magnetic field (130) generated by the planar magnetic arrangement (120) in the useful volume (200) is furthermore formed in the electrically conductive layer (164).

7. Sensor (100) according to one of the preceding claims,
wherein four magnetic poles (131, 132, 133, 134) are formed with respectively alternating orientations on the front side (103) of the planar magnetic arrangement (120), and
wherein the electric coil (140) of the measuring device (102) comprises three windings (151, 152, 153) arranged next to each other, the magnetic poles (151, 152, 153) of which are each arranged between two directly adjacent magnetic poles (131, 132, 133, 134) of the planar magnetic arrangement (120).

8. Sensor (100) according to one of the preceding claims,
wherein an inner shielding structure (161) made of an electrically conductive material with a high magnetic permeability is arranged between the electric coil (140) and the planar magnetic arrangement (120) and acts as a shield for the magnetic segments (121_{i,j}) against the alternating magnetic field (150, 154, 155) of the electric coil (140).

9. Sensor (100) according to one of the preceding claims,
wherein an outer shielding structure (168) made of an electrically conductive material with a high magnetic permeability is arranged between the electric coil (140) and the useful volume (200) and acts as a shield for the electric coil (140) against electromagnetic interference fields.

10. Sensor (100) according to Claim 9,
wherein the outer shielding structure (168) has resonance structures which serve for the targeted shielding against electromagnetic interference fields with frequencies in the range of the network frequency.

11. Sensor (100) according to one of the preceding claims,
wherein the magnetic field generating device (101) comprises a carrier plate (130) made of a non-magnetic material, and wherein the magnetic segments (121_{i,j}) are inserted into at least one opening (111) in the carrier plate (110).

12. Sensor (100) according to Claim 11,
wherein at least some of the magnetic segments (121_{i,j}) of the magnetic arrangement (120) are designed so as to be able to rotate within the carrier plate (110).

13. Sensor (100) according to Claim 11 or 12,
wherein the magnetic field generating device (101) is modularly expandable by arranging a plurality of carrier plates (110, 112) next to each other in at least one of the two directions of extent (X, Y) of the planar magnetic arrangement (120).

14. Sensor (100) according to one of the preceding claims,
wherein magnetic segments (121_{i,j}) are formed in an edge region (127) of the planar magnetic arrangement (120) in order to generate a static magnetic field having a higher magnetic field strength than magnetic segments (121_{i,j}) in a central region (128) of the planar magnetic arrangement (120).

15. Sensor (100) according to Claim 14,
wherein the higher magnetic field strength in the edge region (127) of the planar magnetic arrangement (120) is achieved by magnetic segments (121_{i,j}) which have a higher magnetization and/or a greater vertical extension than magnetic segments (121_{i,j}) in the central region (128) of the planar magnetic arrangement (120).

16. Sensor (100) according to Claim 14 or 15,
wherein a plurality of magnetic segments (121_{i,j}, 124_{i,j}) arranged on top of each other are provided in the edge region (127) of the planar magnetic arrangement (120) in order to achieve the higher magnetic field strength.

17. Sensor (100) according to one of the preceding claims,
wherein at least some of the magnetic segments (121_{i,j}) of the planar magnetic arrangement (120) have a coating made of a plastic.

18. Nuclear magnetic resonance apparatus (300) comprising a sensor (100) according to one of preceding Claims 1 to 17,
wherein the nuclear magnetic resonance apparatus (300) is designed to determine at least one material property of a material sample arranged in a useful volume (200) for a plurality of measuring layers (201, 202, 203) independently of each other.

19. Nuclear magnetic resonance apparatus (300) according to Claim 18,
wherein the nuclear magnetic resonance apparatus (200) comprises a lifting device (310) having at least one electrically and/or manually driven actuator (320, 330) for adjusting the distance between the sensor (100) and a material sample arranged in the useful volume (200).

20. Nuclear magnetic resonance apparatus (300) according to Claim 19,
wherein the actuator (320, 330) comprises a first actuator part (321, 331) carrying the sensor (100) and a second actuator part (322, 332) which is arranged so as to be movable with respect to said first actuator part and which has a contact area (323, 333) for laying on a surface (410) which is fixedly arranged in relation to the material sample.

21. Nuclear magnetic resonance apparatus (300) according to Claim 20,
wherein the first actuator part (321, 331) is designed in the form of an electric motor, and
wherein the second actuator part (322, 332) is designed in the form of a spindle driven by the electric motor.

22. Nuclear magnetic resonance apparatus (300) according to Claim 20,
wherein the lifting device (310) comprises a plurality of actuators (320, 330) arranged distributed along the circumference of the sensor (100).

## Revendications

1. Capteur (100) pour un dispositif de résonance de spin nucléaire (300) pour la détermination d'au moins une propriété de matériau d'un échantillon de matériau disposé dans un volume utile (200), comprenant :
- un dispositif de génération de champ magnétique (101) comprenant un agencement d'aimant plan (120) pour générer un champ magnétique statique (130, 135, 136, 137) dans le volume utile (200), dans lequel l'agencement d'aimant plan (120) présente sur une face avant (103) tournée vers le volume utile (200) plusieurs pôles magnétiques (131, 132, 133, 134) qui sont disposés les uns à côté des autres le long d'une première direction d'extension (X) de l'agencement d'aimant plan (120) avec un alignement respectivement alterné, et
- un dispositif de mesure (102) pour mesurer un signal basé sur la résonance de spin nucléaire de l'échantillon de matériau disposé dans le volume utile (200), comprenant une bobine électrique (140) pourvue d'au moins un enroulement (141, 142, 143, 144) pour générer un champ alternatif magnétique (150, 154, 155) dans le volume utile (200), dans lequel l'enroulement (141, 142, 143, 144) est disposé entre deux pôles magnétiques (131, 132, 133, 134), directement voisins, de l'agencement d'aimant plan (120) de sorte que le champ alternatif magnétique (150, 154, 155) de la bobine électrique (140) se superpose dans tout le volume utile (200) de manière substantiellement orthogonale au champ magnétique statique (130, 135, 136, 137) de l'agencement d'aimant plan (120), dans lequel l'agencement d'aimant plan (120) comprend le long de la première direction d'extension (X) et le long d'une deuxième direction d'extension (Y), qui s'étend perpendiculairement à la première direction d'extension (X), plusieurs segments d'aimant (121_{i,j}) disposés les uns à côté des autres avec des dispositifs de magnétisation alignés respectivement orthogonalement à la deuxième direction d'extension (Y) de l'agencement d'aimant plan (120), et dans lequel des segments d'aimant (121_{i,j}) qui sont disposés directement les uns à côté des autres le long de la première direction d'extension (X) de l'agencement d'aimant plan (120) présentent respectivement des sens de magnétisation tournés les uns par rapport aux autres de sorte que sur la face avant (103) de l'agencement d'aimant plan (120) un champ magnétique statique (130) nettement plus fort est généré que sur la face arrière (104) de l'agencement d'aimant plan (120), dans lequel les segments d'aimant (121_{i,j}) disposés les uns à côté des autres le long de la deuxième direction d'extension (Y) de l'agencement d'aimant plan (120) présentent un même sens de magnétisation, la bobine électrique (140) étant réalisée sous la forme d'une bobine multirésonante.

2. Capteur (100) selon la revendication 1,
dans lequel des segments d'aimant (121_{i,j}) disposés directement les uns à côté des autres le long de la première direction d'extension (X) de l'agencement d'aimant plan (120) présentent respectivement des sens de magnétisation tournés de 45° les uns par rapport aux autres.

3. Capteur (100) selon l'une quelconque des revendications 1 à 2,
dans lequel la bobine électrique (140) est en outre réalisée pour mesurer un signal basé sur la résonance de spin nucléaire de l'échantillon de matériau disposé dans le volume utile (200).

4. Capteur (100) selon l'une quelconque des revendications précédentes,
dans lequel la bobine électrique (140) est disposée sur la face avant (103) de l'agencement d'aimant plan (120).

5. Capteur (100) selon l'une quelconque des revendications précédentes,
dans lequel la bobine électrique (140) est réalisée sous la forme d'une couche électriquement conductrice (164) structurée.

6. Capteur (100) selon la revendication 5,
dans lequel en outre au moins une bobine de shim est réalisée dans la couche électriquement conductrice (164) pour homogénéiser le champ magnétique statique (130) généré par l'agencement d'aimant plan (120) dans le volume utile (200).

7. Capteur (100) selon l'une quelconque des revendications précédentes,
dans lequel quatre pôles magnétiques (131, 132, 133, 134) avec respectivement des alignements alternés sont réalisés sur la face avant (103) de l'agencement d'aimant plan (120), et
dans lequel la bobine électrique (140) du dispositif de mesure (102) comprend trois enroulements (151, 152, 153) disposés les uns à côtés des autres dont les pôles magnétiques (151, 152, 153) sont disposés respectivement entre deux pôles magnétiques (131, 132, 133, 134), directement voisins, de l'agencement d'aimant plan (120).

8. Capteur (100) selon l'une quelconque des revendications précédentes,
dans lequel entre la bobine électrique (140) et l'agencement d'aimant plan (120) est disposée une structure de blindage intérieure (161) d'un matériau électriquement conducteur ayant une haute perméabilité magnétique, qui sert de blindage aux segments d'aimant (121_{i,j}) contre le champ alternatif magnétique (150, 154, 155) de la bobine électrique (140).

9. Capteur (100) selon l'une quelconque des revendications précédentes,
dans lequel entre la bobine électrique (140) et le volume utile (200) est disposée une structure de blindage extérieure (168) d'un matériau électriquement conducteur ayant une haute perméabilité magnétique, qui sert de blindage à la bobine électrique (140) contre des champs parasites électromagnétiques.

10. Capteur (100) selon la revendication 9,
dans lequel la structure de blindage extérieure (168) présente des structures de résonance qui servent au blindage ciblé de champs parasites électromagnétiques ayant des fréquences dans la plage de la fréquence du réseau.

11. Capteur (100) selon l'une quelconque des revendications précédentes,
dans lequel le dispositif de génération de champ magnétique (101) comprend une plaque de support (130) d'un matériau non magnétique, et dans lequel les segments d'aimant (121_{i,j}) sont introduits dans au moins une ouverture (111) de la plaque de support (110).

12. Capteur (100) selon la revendication 11,
dans lequel au moins une partie des segments d'aimant (121_{i,j}) de l'agencement d'aimant (120) est réalisée de manière rotative à l'intérieur de la plaque de support (110).

13. Capteur (100) selon la revendication 11 ou 12,
dans lequel le dispositif de génération de champ magnétique (101) peut être étendu de manière modulaire en disposant côte à côte plusieurs plaques de support (110, 112) dans au moins l'une des deux directions d'extension (X, Y) de l'agencement d'aimant plan (120).

14. Capteur (100) selon l'une quelconque des revendications précédentes,
dans lequel des segments d'aimant (121_{i,j}) dans une zone marginale (127) de l'agencement d'aimant plan (120) sont réalisés pour générer un champ magnétique statique ayant une intensité de champ magnétique plus élevée que des segments d'aimant (121_{i,j}) dans une zone centrale (128) de l'agencement d'aimant plan (120).

15. Capteur (100) selon la revendication 14,
dans lequel l'intensité de champ magnétique plus élevée dans la zone marginale (127) de l'agencement d'aimant plan (120) est obtenue par des segments d'aimant (121_{i,j}) qui présentent une magnétisation plus élevée et/ou une extension verticale plus grande que des segments d'aimant (121_{i,j}) dans la zone centrale (128) de l'agencement d'aimant plan (120).

16. Capteur (100) selon la revendication 14 ou 15,
dans lequel, dans la zone marginale (127) de l'agencement d'aimant plan (120), plusieurs segments d'aimant (121_{i,j}, 124_{i,j}) disposés les uns au-dessus des autres sont prévus pour obtenir l'intensité de champ magnétique plus élevée.

17. Capteur (100) selon l'une quelconque des revendications précédentes,
dans lequel au moins une partie des segments d'aimant (121_{i,j}) de l'agencement d'aimant plan (120) présente un enrobage de matière plastique.

18. Dispositif de résonance de spin nucléaire (300), comprenant un capteur (100) selon l'une quelconque des revendications précédentes 1 à 17,
dans lequel le dispositif de résonance de spin nucléaire (300) est réalisé pour déterminer au moins une propriété de matériau d'un échantillon de matériau disposé dans un volume utile (200) pour plusieurs couches de mesure (201, 202, 203) indépendamment les unes des autres.

19. Dispositif de résonance de spin nucléaire (300) selon la revendication 18,
dans lequel le dispositif de résonance de spin nucléaire (200) comprend un dispositif de levage (310) pourvu d'au moins un actionneur (320, 330) à entraînement électrique et/ou manuel pour régler la distance entre le capteur (100) et un échantillon de matériau disposé dans le volume utile (200).

20. Dispositif de résonance de spin nucléaire (300) selon la revendication 19,
dans lequel l'actionneur (320, 330) comprend une première partie d'actionneur (321, 331) portant le capteur (100) et une deuxième partie d'actionneur (322, 332) disposée de manière mobile par rapport à celle-ci et pourvue d'une surface de pose (323, 333) à poser sur une surface (410) disposée de manière stationnaire par rapport à l'échantillon de matériau.

21. Dispositif de résonance de spin nucléaire (300) selon la revendication 20,
dans lequel la première partie d'actionneur (321, 331) est réalisée sous la forme d'un moteur électrique, et
dans lequel la deuxième partie d'actionneur (322, 332) est réalisée sous la forme d'une broche entraînée par le moteur électrique.

22. Dispositif de résonance de spin nucléaire (300) selon la revendication 20,
dans lequel le dispositif de levage (310) comprend plusieurs actionneurs (320, 330) répartis le long de la circonférence du capteur (100).
